# EUROPEAN PATENT APPLICATION

(11) **EP 1 469 057 A2**
(43) Date of publication of application: **20.10.2004**
(21) Application number: 04008454.3
(22) Date of filing: 07.04.2004
(51) Int. Cl.: C09K 11/06, H01L 51/30

(54) **Polymer, polymer for forming organic electroluminescence device, polymer composition for organic electroluminescence device and organic electroluminescence device**

(30) Priority: 08.04.2003 JP 2003103545; 01.10.2003 JP 2003343520; 10.12.2003 JP 2003411821
(71) Applicant: JSR Corporation, Tokyo 104-0045 (JP)
(72) Inventor: Yasuda, Hiroyuki, Tokyo 104-0045 (JP); Shiraki, Shinji, Tokyo 104-0045 (JP); Nishikawa, Michinori, Tokyo 104-0045 (JP); Ryou, Tou, Tokyo 104-0045 (JP); Makita, Yutaka, Tokyo 104-0045 (JP)
(74) Representative: Leson, Thomas Johannes Alois, Dipl.-Ing.

(57) **Abstract**

Disclosed herein are a polymer for forming an organic electroluminescence device and a polymer composition for organic electroluminescence devices, by which a thin film can be formed with ease by the wet method, and an organic electroluminescence device that can achieve light emission high in luminous luminance and stable even during continuous driving can be provided, and the organic electroluminescence device.

The polymer for forming an organic electroluminescence device has specific structural units in its main chain. The polymer composition for organic electroluminescence devices comprises a polymer component composed of the polymer for forming an organic electroluminescence device, and a complex component composed of an iridium complex compound that is a triplet luminescent material. The organic electroluminescence device comprises a functional organic layer having a function as a luminescent layer or charge transport layer formed by the polymer for forming an organic electroluminescence device or the polymer composition for organic electroluminescence devices.

## Description

### BACKGROUND OF THE INVENTION

### Field of the Invention:

The present invention relates to a novel polymer, a polymer suitably used in forming an organic electroluminescence device, a polymer composition for organic electroluminescence devices and an organic electroluminescence device.

### Description of the Background Art:

An organic electroluminescence device (hereinafter also referred to as "organic EL device") is expected as a display element of the coming generation because it has such excellent properties as can be driven by DC voltage, is wide in angle of visibility and high in visibility owing to its self-luminescent nature, and is fast in the speed of response, and researches thereof are being actively conducted.

As such organic EL devices, there have heretofore been known those of a single-layer structure that a luminescent layer composed of an organic material is formed between an anode and a cathode, and those of multi-layer structures such as a structure having a hole transport layer between an anode and a luminescent layer and a structure having an electron transport layer between a cathode and a luminescent layer. In all of these organic EL devices, light is emitted by recombining an electron injected from the cathode with a hole injected from the anode in the luminescent layer.

As processes for forming functional organic layers such as the luminescent layer and the charge transport layers for transporting a charge such as an electron or hole in such an organic EL device, there have been known a dry method that an organic material layer is formed by vacuum deposition and a wet method that a solution with an organic material dissolved therein is applied and dried to form a layer. Among these, the dry method is difficult to meet mass production because the process is complicated, and there is a limit to the formation of a large-area layer. On the contrary, the wet method can meet mass production because the process is relatively simple. For example, a large-area functional organic layer can be easily formed according to an ink-jet method. In these respects, the wet method is useful compared with the dry method.

On the other hand, the functional organic layer making up the luminescent layer of the organic EL device is required to achieve high luminous luminance. In order to realize high luminous luminance, it has been recently attempted to utilize energy of a molecule in a triplet state that is an excitation state, or the like for light emission of an organic EL device. Specifically, it has been reported to achieve an external quantum efficiency of 8% exceeding 5% that has heretofore been considered to be a critical value of the external quantum efficiency in an organic EL device according to an organic EL device having such construction (see for example, "Applied Physics Letters", Vol. 75, p. 4, 1999).

Since this organic EL device is formed with a low-molecular weight material by the dry method, for example, a vapor deposition method or the like, however, it involves a problem that its physical durability and thermal durability are low.

As the organic EL device utilizing energy of the molecule in the triplet state or the like, there has been proposed that obtained by forming a luminescent layer with a composition composed of, for example, an iridium metal complex, polyvinylcarbazole and oxadiazole by the wet method (see Japanese Patent Application Laid-Open No. 2001-257076).

In this organic EL device, the luminescent layer contains low-molecular weight oxadiazole. This low-molecular weight oxadiazole is low in stability to Joule heat generated during continuous driving. Accordingly, this organic EL device involves a problem that stable light emission cannot be achieved during continuous driving.

### SUMMARY OF THE INVENTION

The present invention has been made on the basis of the foregoing circumstances and has as its object the provision of a novel polymer suitable for a forming material of, for example, an organic electroluminescence device, and a polymer for forming an organic electroluminescence device and a polymer composition for organic electroluminescence devices, by which a thin film can be formed with ease by the wet method, and an organic electroluminescence device that can achieve light emission high in luminous luminance and stable even during continuous driving can be provided.

Another object of the present invention is to provide an organic electroluminescence device that can achieve light emission high in luminous luminance and stable even during continuous driving.

According to the present invention, there is thus provided a polymer for forming an organic electroluminescence device, which is composed of a polymer having, in its main chain, a structural unit represented by the following general formula (1-a) and a structural unit represented by the following general formula (1-b): 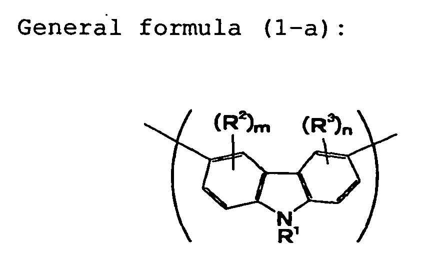 wherein R¹ is an alkyl group or, an aromatic group which may be substituted, R² and R³ are, independently of each other, a monovalent organic group and may be the same or different from each other, m is an integer of 0 to 3, and n is an integer of 0 to 3; and 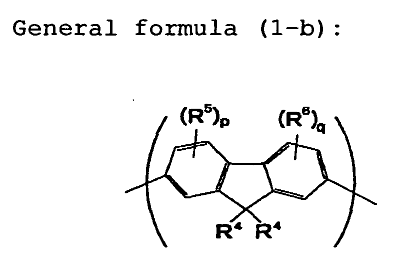 wherein R⁴ is an alkyl group, R⁵ and R⁶ are, independently of each other, a monovalent organic group and may be the same or different from each other, p is an integer of 0 to 3, and q is an integer of 0 to 3, and;
the polymer being used for forming an electroluminescence device.

The polymer according to the present invention for forming an organic electroluminescence device may comprise a structural unit represented by the following general formula (a): 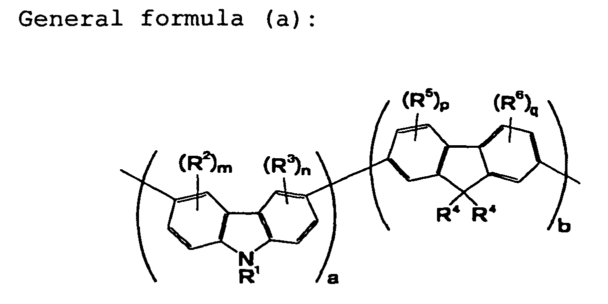 wherein R¹ is an alkyl group or, an aromatic group which may be substituted, R² and R³ are, independently of each other, a monovalent organic group and may be the same or different from each other, R⁴ is an alkyl group, R⁵ and R⁶ are, independently of each other, a monovalent organic group and may be the same or different from each other, m is an integer of 0 to 3, n is an integer of 0 to 3, p is an integer of 0 to 3, q is an integer of 0 to 3, and a and b are the numbers of repeated structural units.

The polymer according to the present invention for forming an organic electroluminescence device may also comprise a structural unit represented by the following general formula (b): 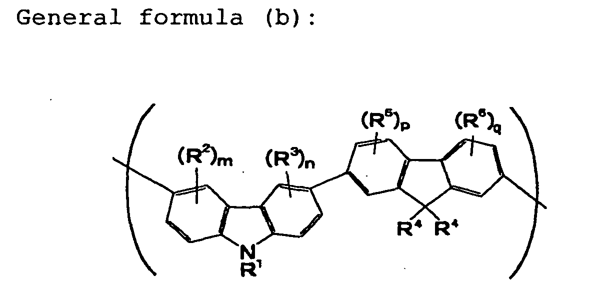 wherein R¹ is an alkyl group or, an aromatic group which may be substituted, R² and R³ are, independently of each other, a monovalent organic group and may be the same or different from each other, R⁴ is an alkyl group, R⁵ and R⁶ are, independently of each other, a monovalent organic group and may be the same or different from each other, m is an integer of 0 to 3, n is an integer of 0 to 3, p is an integer of 0 to 3, and q is an integer of 0 to 3.

The polymer according to the present invention for forming an organic electroluminescence device may have a weight average molecular weight of 5,000 to 1,000,000 in terms of polystyrene as measured by gel permeation chromatography.

According to the present invention, there is also provided a polymer composition for organic electroluminescence devices, comprising a polymer component composed of the above-described polymer for forming an organic electroluminescence device, and a complex component composed of an iridium complex compound that is a triplet luminescent material.

According to the present invention, there is further provided an organic electroluminescence device comprising a functional organic layer having a function as a luminescent layer or charge transport layer formed by the above-described polymer composition for organic electroluminescence devices.

According to the present invention, there is provided a polymer having, in its main chain, a structural unit represented by the following general formula (2-a) and a structural unit represented by the following general formula (2-b): 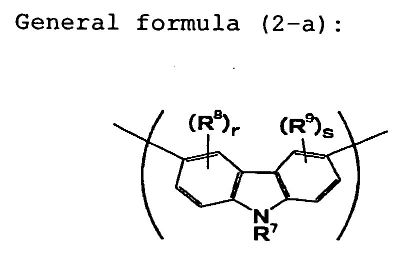 wherein R⁷ is an alkyl group or, an aromatic group which may be substituted, R⁸ and R⁹ are, independently of each other, a monovalent organic group and may be the same or different from each other, r is an integer of 0 to 3, and s is an integer of 0 to 3; and 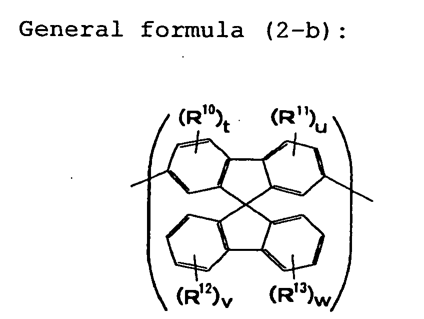 wherein R¹⁰ and R¹¹ are, independently of each other, a monovalent organic group and may be the same or different from each other, R¹² and R¹³ are, independently of each other, a monovalent organic group and may be the same or different from each other, t is an integer of 0 to 3, u is an integer of 0 to 3, v is an integer of 0 to 4, and w is an integer of 0 to 4.

According to the present invention, there is also provided a polymer for forming an organic electroluminescence device, which is composed of the polymer described above and is used for forming an electroluminescence device.

The polymer according to the present invention for forming an organic electroluminescence device may comprise a structural unit represented by the following general formula (c): 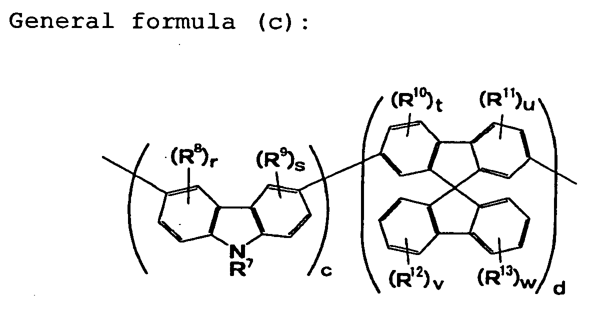 wherein R⁷ is an alkyl group or, an aromatic group which may be substituted, R⁸ and R⁹ are, independently of each other, a monovalent organic group and may be the same or different from each other, R¹⁰ and R¹¹ are, independently of each other, a monovalent organic group and may be the same or different from each other, R¹² and R¹³ are, independently of each other, a monovalent organic group and may be the same or different from each other, r is an integer of 0 to 3, s is an integer of 0 to 3, t is an integer of 0 to 3, u is an integer of 0 to 3, v is an integer of 0 to 4, w is an integer of 0 to 4, and c and d are the numbers of repeated structural units.

In the polymer described above, a ratio (d/c) of the numbers c and d of repeated structural units in the general formula (c) may preferably be 1 to 5.

In the polymer for forming an organic electroluminescence device, the polymer may preferably be obtained by subjecting a monomer having 2 functional groups selected from reactive halide functional groups and boron derivative functional groups and a skeletal structure derived from carbazole, and a monomer having 2 functional groups selected from reactive halide functional groups and boron derivative functional groups and a skeletal structure derived from spirofluorene to a coupling reaction in the presence of a palladium catalyst.

The polymer according to the present invention for forming an organic electroluminescence device may have a weight average molecular weight of 5,000 to 1,000,000 in terms of polystyrene as measured by gel permeation chromatography.

According to the present invention, there is further provided a polymer composition for organic electroluminescence devices, comprising a polymer component composed of the above-described polymer for forming an organic electroluminescence device, and a complex component composed of an iridium complex compound that is a triplet luminescent material.

According to the present invention, there is still further provided an organic electroluminescence device comprising a functional organic layer having a function as a luminescent layer or charge transport layer formed by the above-described polymer for forming an organic electroluminescence device.

According to the present invention, there is yet still further provided an organic electroluminescence device comprising a functional organic layer having a function as a luminescent layer or charge transport layer formed by the above-described polymer composition for organic electroluminescence devices.

The organic electroluminescence devices may preferably have a hole blocking layer.

According to the present invention, polymers suitably used in forming organic electroluminescence devices are provided.

According to the polymers of the present invention for forming organic electroluminescence devices, thin film-like organic electroluminescence devices that can achieve light emission high in luminous luminance and stable even during continuous driving can be formed with ease by the wet method because the polymers are each composed of a specific conjugated polymer having the specific structural unit(s).

A polymer component composed of the polymer for forming an organic electroluminescence device is combined with a complex component composed of an iridium complex compound that is a triplet luminescent material, whereby a polymer composition for organic electroluminescence devices, by which a thin film can be formed with ease by the wet method, can be provided. According to such a polymer composition, an organic electroluminescence device that can achieve light emission high in luminous luminance and stable even during continuous driving can be provided.

According to the organic electroluminescence devices of the present invention, light emission high in luminous luminance and stable even during continuous driving can be achieved.

### BRIEF DESCRIPTION OF THE DRAWING

The above and other objects, features and advantages of the present invention will become apparent from the following description and the appended claims, taken in conjunction with the accompanying drawings, in which:
Fig. 1 is a cross-sectional view illustrating the construction of an exemplary organic electroluminescence device according to the present invention;
Fig. 2 is a cross-sectional view illustrating the construction of another exemplary organic electroluminescence device according to the present invention;
Fig. 3 illustrates a chart of a ¹³C-NMR spectrum obtained by NMR measurement in Polymerization Example (1); and
Fig. 4 illustrates a chart of a ¹H-NMR spectrum obtained by NMR measurement in Polymerization Example (1)

### DETAILED DESCRIPTION OF THE PREFERRED EMBODIMENTS

The embodiments of the present invention will hereinafter be described in details.

### <Polymer for Forming Organic EL Device>

As the polymers according to the present invention for forming an organic EL device, are proposed a conjugated polymer (hereinafter also referred to as "first conjugated polymer") having a structural unit (hereinafter also referred to as "carbazole structural unit (1)") represented by the general formula (1-a) and a structural unit (hereinafter also referred to as "fluorene structural unit") represented by the general formula (1-b) in its main chain, and a conjugated polymer (hereinafter also referred to as "second conjugated polymer") having a structural unit (hereinafter also referred to as "carbazole structural unit (2)") represented by the general formula (2-a) and a structural unit (hereinafter also referred to as "spirofluorene structural unit") represented by the general formula (2-b) in its main chain, which are both used for forming an organic EL device.

### [First Conjugated Polymer]

The first conjugated polymer making up the polymer according to the present invention for forming an organic EL device is composed of a conjugated polymer having the carbazole structural unit (1) and the fluorene structural unit in its main chain.

The first conjugated polymer may be any of a random copolymer, block copolymer and alternating copolymer of the carbazole structural unit (1) and the fluorene structural unit.

In the general formula (1-a) representing the carbazole structural unit (1), R¹ is an alkyl group or, an aromatic group which may be substituted, and is particularly preferably an ethyl group.

R² and R³ are, independently of each other, a monovalent organic group and may be the same or different from each other. However, they may preferably be the same.

Examples of the monovalent organic group in each of R² and R³ include methyl, ethyl, propyl, isopropyl and phenyl groups.

m and n are, independently of each other, an integer of 0 to 3 and may be particularly preferably both 0. The fact that m and n are 0 means no substituent group is bonded, but a hydrogen atom is bonded.

As a specific preferable example of the carbazole structural unit (1), may be mentioned a structural unit in which R¹ is an ethyl group, and both m and n are 0.

In the general formula (1-b) representing the fluorene structural unit, R⁴ is an alkyl group and is particularly preferably a hexyl or octyl group.

R⁵ and R⁶ are, independently of each other, a monovalent organic group and may be the same or different from each other. However, they may preferably be the same.

Examples of the monovalent organic group in each of R⁵ and R⁶ include alkyl groups having 1 to 22 carbon atoms, heteroaryl groups having 2 to 20 carbon atoms, aryl groups having 6 to 20 carbon atoms, alkoxyl groups having 1 to 20 carbon atoms, a nitrile group and aromatic amino groups. Among these, t-butyl, diphenylamino, tolyl, methoxy and cyano groups are particularly preferred.

p and q are, independently of each other, an integer of 0 to 3 and may be particularly preferably both 0. The fact that m and n are 0 means no substituent group is bonded, but a hydrogen atom is bonded.

As a specific preferable example of the fluorene structural unit, may be mentioned a structural unit in which R⁴ is a hexyl or octyl group, and both p and q are 0.

As specific preferable examples of the first conjugated polymer, may be mentioned those respectively containing the structural units represented by the general formulae (a) and (b). When the first conjugated polymer is a polymer containing the structural unit represented by the general formula (a), the ratio a:b of the repeated number a of carbazole structural units to the repeated number b of fluorene structural units is preferably 2:8 to 8:2 though not particularly limited.

The first conjugated polymer preferably has a weight average molecular weight of 5,000 to 1,000,000, particularly 10,000 to 500,000 in terms of polystyrene as measured by gel permeation chromatography. If the weight average molecular weight is lower than 5,000, such a polymer and the resulting polymer composition have a possibility that heat resistance and, stability and mechanical strength in a state of a thin film may be insufficient. If the weight average molecular weight exceeds 1,000,000 on the other hand, the resulting polymer composition tends to be markedly high in its solution viscosity, and so the handling property thereof may possibly be lowered in the production of organic EL devices. It is hence not preferable to use a polymer having such too low or high molecular weight.

The molecular weight distribution of the first conjugated polymer is preferably at most 5.

Such a first conjugated polymer can be formed in accordance with, for example, the method (hereinafter referred to as "Suzuki's method") disclosed in Organometallics 3, 1261 (1984), the method (hereinafter referred to as "Yamamoto's method") disclosed in Progress in Polymer Science Vol. 17, 1153 (1992), or the like.

The first conjugated polymer formed by the Suzuki's method becomes an alternating copolymer containing the structural unit represented by the general formula (b), while the first conjugated polymer formed by the Yamamoto's method becomes a random copolymer containing the structural unit represented by the general formula (a).

According to the Suzuki's method, the first conjugated polymer is formed by reacting a monomer (hereinafter referred to as "carbazole skeletal monomer") having 2 specific functional groups and a skeletal structure derived from carbazole and a monomer (hereinafter referred to as "fluorene skeletal monomer") having 2 specific functional groups and a skeletal structure derived from fluorene in the presence of a basic compound and a palladium catalyst in a reaction solvent.

In this specification, the term "specific functional groups" indicate reactive halide functional groups and boron derivative functional groups.

Combinations of the carbazole skeletal monomer and fluorene skeletal monomer used in the Suzuki's method include the following 3 combinations:
(1) A combination that a compound having 2 reactive halide functional groups is used as the carbazole skeletal monomer, and a compound having 2 boron derivative functional groups is used as the fluorene skeletal monomer;
(2) A combination that a compound having 2 boron derivative functional groups is used as the carbazole skeletal monomer, and a compound having 2 reactive halide functional groups is used as the fluorene skeletal monomer; and
(3) A combination that a compound having a reactive halide functional group and a boron derivative functional group is used as the carbazole skeletal monomer, and a compound having a reactive halide functional group and a boron derivative functional group is used as the fluorene skeletal monomer.

In the carbazole skeletal monomer, the 2 specific functional groups are preferably bonded to carbon atoms located at positions 3 and 6, respectively.

In the fluorene skeletal monomer, the 2 specific functional groups are preferably bonded to carbon atoms located at positions 2 and 7, respectively.

Examples of the reactive halide functional groups include a -Cl group, a -Br group, an -I group, groups derived from triflate (CF₃SO₃⁻), groups derived from tosylate and groups derived from mesylate.

Among these, the -Br and -I groups are preferred.

Examples of the boron derivative functional groups include a boric group represented by the formula -B(OH)₂, borate groups and borane groups.

As the borate groups, are preferred groups represented by the formula -B (OR¹⁴) (OR¹⁵) and groups represented by the formula -B(OR¹⁶O).

As the borane groups, are preferred groups represented by the formula -BR¹⁷R¹⁸.

R¹⁴ in the borate groups is an alkyl group which has 1 to 6 carbon atoms and may be substituted.

R¹⁵ is a hydrogen atom or an alkyl group which has 1 to 6 carbon atoms and may be substituted.

R¹⁶ is such a divalent hydrocarbon group that (OR ¹⁶O) in the formula becomes a 5-membered or 6-membered ester ring. Specifically, it is preferably an alkylene group having 2 or 3 carbon atoms, an o-phenylene group or a m-phenylene group. These alkylene groups and phenylene groups may be substituted.

Examples of preferable groups as the borate groups of such a structure include groups derived from products by esterification of an alcohol having 1 to 6 carbon atoms, an ethanediol such as pinacol, propanediol, or an ortharomatic diol such as 1,2-dihydroxybenzene with its corresponding boric acid.

R¹⁷ and R¹⁸ in the borane groups are, independently of each other, an alkyl group which has 1 to 6 carbon atoms and may be substituted. These groups may or may not form a ring together.

As specific preferable examples of the carbazole skeletal monomer and fluorene skeletal monomer used in the Suzuki's method, may be mentioned a compound represented by the following formula (A) for the carbazole skeletal monomer and a compound represented by the following formula (B) for the fluorene skeletal monomer.

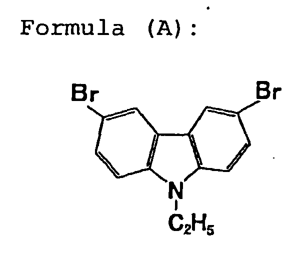

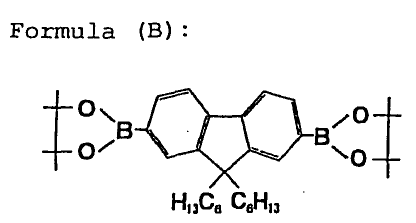

Water, an inert organic solvent or a mixture of water and an inert organic solvent may be used as the reaction solvent. Among these, the mixture of water and the inert organic solvent is preferably used.

Examples of the inert organic solvent include ethers such as dimethoxyethane, diethylene glycol dimethyl ether, tetrahydrofuran, dioxane, diisopropyl ether and tert-butyl methyl ether; hydrocarbons such as hexane, heptane, cyclohexane, toluene and xylene; alcohols such as methanol, ethanol, 1-propanol, 2-propanol, 1-butyl alcohol, tert-butyl alcohol and ethylene glycol; ketones such as ethyl methyl ketone and isobutyl methyl ketone; amides such as dimethylformamide, dimethylacetamide and N-methylpyrrolidone; and mixtures thereof. These inert organic solvents may be used either singly or in any combination thereof.

Among these, dimethoxyethane, tetrahydrofuran, cyclohexane, toluene, xylene, ethanol, 1-propanol, 2-propanol, 1-butyl alcohol, tert-butyl alcohol and mixtures thereof are preferably used.

Specific preferable examples of the reaction solvent include a mixture of water and toluene, a mixture of water, toluene and tetrahydrofuran and a mixture of water, toluene and ethanol.

The amount of the reaction solvent used varies according to the kinds of the monomers used in the reaction, but is generally a proportion that the total concentration of the monomers used in the reaction amounts to 9 to 30 % by mass.

As the basic compound, may be used, for example, an alkali metal hydroxide, alkaline earth metal hydroxide, alkali metal carbonate, alkaline earth metal carbonate, alkali metal acetate, alkaline earth metal acetate, alkali metal hydrogencarbonate, alkaline earth metal hydrogencarbonate, alkali metal alkoxide, alkaline earth metal alkoxide, primary amine, secondary amine or tertiary amine.

Among these, alkali metal hydroxides such as sodium hydroxide and potassium hydroxide, alkali metal carbonates such as lithium carbonate, sodium carbonate and potassium carbonate, and alkali metal hydrogencarbonates are preferably used.

The amount of the basic compound used is preferably 100 to 500 mol%, particularly preferably 150 to 400 mol%, most preferably 180 to 250 mol% based on the total moles of the boron derivative functional groups in the monomers used in the reaction.

As the palladium catalyst, may be used a palladium(0) complex or palladium(II) salt. However, the palladium(0) complex is preferably used.

Among these, tetrakis(triphenylphosphine)palladium (Pd(PPh₃)₄) is preferably used.

The amount of the palladium catalyst used is 0.01 to 5 mol%, preferably 0.05 to 3 mol%, particularly preferably 0.1 to 1.5 mol% based on the total moles of the monomers used in the reaction.

The reaction temperature is 0 to 200°C, preferably 30 to 170°C, particularly preferably 50 to 150°C, most preferably 60 to 120°C.

The reaction time is 1 to 200 hours, preferably 5 to 150 hours, particularly preferably 24 to 100 hours.

According to the Yamamoto's method on the other hand, the first conjugated polymer is formed by subjecting a monomer compound (hereinafter referred to as "halogenated fluorene compound") having 2 reactive halide functional groups and a skeletal structure derived from fluorene and a monomer compound (hereinafter referred to as "halogenated carbazole compound") having 2 reactive halide functional groups and a skeletal structure derived from carbazole to a coupling reaction in the presence of a nickel catalyst.

As examples of the reactive halide functional groups, may be mentioned -Br, -Cl and -I groups. Among these, the -Br group is preferably used.

Examples of the halogenated carbazole compound include compounds that the hydrogen atom bonded to the nitrogen atom of carbazole is substituted by an alkyl group having 1 to 22 carbon atoms or an aromatic group having 1 to 3 ring(s) (for example, phenyl, naphthyl, anthryl or xylylene group) which may be substituted.

Among these, N-ethyldibromocarbazole and N-phenylbromocarbazole are preferred.

As examples of the halogenated fluorene compound, may be mentioned di(2-ethylhexyl)dibromofluorene, dihexyldibromofluorene, dioctyldibromofluorene and di(methoxycarbonylethyl)dibromofluorene.

Among these, dihexyldibromofluorene and dioctyldibromofluorene are preferred.

Examples of the nickel catalyst include nickel of 0 valence, bis(1,5-cyclooctadienyl)nickel(0), tetrakis-(triphenylphosphite) nickel (0) and tetrakis(triphenylphosphine)nickel(0). Bis(1,5-cyclooctadienyl)nickel(0) is particularly preferably used.

The amount of the nickel catalyst used is 50 to 500 mol%, preferably 70 to 400 mol%, particularly preferably 100 to 200 mol% based on the total moles of the monomers used in the reaction.

The reaction temperature is 50 to 120°C, preferably 60 to 100°C, particularly preferably 70 to 90°C.

The reaction time is 1 to 100 hours, preferably 3 to 80 hours, particularly preferably 6 to 70 hours.

The reaction product obtained by the polymerization process according to each of the Suzuki's method and Yamamoto's method is preferably subjected to a post treatment that a low-molecular weight component is removed by, for example, preparative gel permeation chromatography. An organic EL device still higher in luminous efficiency can be provided by conducting such a post treatment.

The polymer for forming an organic EL device composed of such a first conjugated polymer as described above is used in formation of an organic EL device as a material for forming a functional organic layer such as a luminescent layer or charge transport layer by using it singly or together with, for example, a luminescent material having phosphorescent property.

### [Second Conjugated Polymer]

The second conjugated polymer making up the polymer according to the present invention for forming an organic EL device is composed of a conjugated polymer having the carbazole structural unit (2) and the spirofluorene structural unit in its main chain.

The second conjugated polymer may be any of a random copolymer, block copolymer and alternating copolymer of the carbazole structural unit (2) and the spirofluorene structural unit.

In the general formula (2-a) representing the carbazole structural unit (2), R⁷ is an alkyl group or an aromatic group having 1 to 3 ring(s) (for example, phenyl, naphthyl, anthryl or xylylene group) which may be substituted, and is particularly preferably an alkyl group having 2 to 8 carbon atoms.

R⁸ and R⁹ are, independently of each other, a monovalent organic group and may be the same or different from each other. However, they may preferably be the same.

Examples of the monovalent organic group in each of R⁸ and R⁹ include methyl, ethyl, propyl, isopropyl and phenyl groups.

r and s are, independently of each other, an integer of 0 to 3 and may be particularly preferably both 0. The fact that r and s are 0 means no substituent group is bonded, but a hydrogen atom is bonded.

As a specific preferable example of the carbazole structural unit (2), may be mentioned a structural unit in which R⁷ is an octyl group, and both r and s are 0.

In the general formula (2-b) representing the spirofluorene structural unit, R¹⁰ and R¹¹ are, independently of each other, a monovalent organic group and may be the same or different from each other. However, they may preferably be the same.

Examples of the monovalent organic group in each of R¹⁰ and R¹¹ include alkyl groups having 1 to 22 carbon atoms, heteroaryl groups having 2 to 20 carbon atoms, aryl groups having 6 to 20 carbon atoms, alkoxyl groups having 1 to 20 carbon atoms, aromatic amino groups having 6 to 20 carbon atoms, and nitrile groups having 1 to 20 carbon atoms. Among these, t-butyl, diphenylamino, tolyl, methoxy and cyano groups are particularly preferred.

These groups may be aromatic heterocyclic groups having a nitrogen atom, oxygen atom and/or sulfur atom as hetero-atom(s) and 1 to 30 carbon atoms. Examples of such aromatic heterocyclic groups include pyridyl, thiophenyl and oxadiazolyl groups.

t and u are, independently of each other, an integer of 0 to 3 and may be particularly preferably both 0. The fact that t and u are 0 means no substituent group is bonded, but a hydrogen atom is bonded.

R¹² and R¹³ are, independently of each other, a monovalent organic group and may be the same or different from each other. However, they may preferably be the same.

Examples of the monovalent organic group represented by each of R¹² and R¹³ include the same groups as those mentioned above as R¹⁰ and R¹¹. Among these, t-butyl, diphenylamino, tolyl, methoxy and cyano groups are particularly preferred.

v and w are, independently of each other, an integer of 0 to 4 and may be particularly preferably both 1. The fact that t and u are 0 means no substituent group is bonded, but a hydrogen atom is bonded.

As a specific preferable example of the spirofluorene structural unit, may be mentioned a structural unit in which both t and u are 0, both R¹² and R¹³ are t-butyl groups, and both v and W are 1.

As specific preferable examples of the second conjugated polymer, may be mentioned those containing the structural unit represented by the general formula (c). When the second conjugated polymer is a polymer containing the structural unit represented by the general formula (c), the ratio (d/c) of the repeated number d of repeated spirofluorene structural units to the repeated number c of repeated carbazole structural units is 1 to 5, preferably 1.1 to 5, particularly preferably 1.5 to 3.

The second conjugated polymer preferably has a weight average molecular weight of 5,000 to 1,000,000, particularly 10,000 to 500,000 in terms of polystyrene as measured by gel permeation chromatography. If the weight average molecular weight is lower than 5,000, such a polymer and the resulting polymer composition have a possibility that heat resistance and, stability and mechanical strength in a state of a thin film may be insufficient. If the weight average molecular weight exceeds 1,000,000 on the other hand, the resulting polymer composition tends to be markedly high in its solution viscosity, and so the handling property thereof may possibly be lowered in the production of organic EL devices. It is hence not preferable to use a polymer having such too low or high molecular weight.

The molecular weight distribution of the second conjugated polymer is preferably at most 5.

Such a second conjugated polymer can be formed in accordance with, for example, the Suzuki's method or the like.

The second conjugated polymer formed by the Suzuki's method becomes a random copolymer containing, for example, the structural unit represented by the general formula (c).

According to the Suzuki's method, the second conjugated polymer is formed by subjecting a monomer (carbazole skeletal monomer) having 2 specific functional groups and a skeletal structure derived from carbazole and a monomer (hereinafter referred to as "spirofluorene skeletal monomer") having 2 specific functional groups and a skeletal structure derived from spirofluorene to a coupling reaction in the presence of a basic compound and a palladium catalyst in a reaction solvent.

Combinations of the carbazole skeletal monomer and spirofluorene skeletal monomer used in the Suzuki's method include the following 4 combinations:
(1) A combination that a compound having 2 reactive halide functional groups is used as the carbazole skeletal monomer, and a compound having 2 boron derivative functional groups is used as the spirofluorene skeletal monomer;
(2) A combination that a compound having 2 boron derivative functional groups is used as the carbazole skeletal monomer, and a compound having 2 reactive halide functional groups is used as the spirofluorene skeletal monomer;
(3) A combination that a compound having 2 reactive halide functional groups is used as the carbazole skeletal monomer, and a compound having 2 boron derivative functional groups and a compound having 2 reactive halide functional groups are used as the spirofluorene skeletal monomers; and
(4) A combination that a compound having a reactive halide functional group and a boron derivative functional group is used as the carbazole skeletal monomer, and a compound having a reactive halide functional group and a boron derivative functional group is used as the spirofluorene skeletal monomer.

In the carbazole skeletal monomer, the 2 specific functional groups are preferably bonded to carbon atoms located at positions 3 and 6, respectively.

In the spirofluorene skeletal monomer, the 2 specific functional groups are preferably bonded to carbon atoms located at positions 2 and 7, respectively.

Examples of the reactive halide functional groups include a -Cl group, a -Br group, a -I group, groups derived from triflate (CF₃SO₃⁻) , groups derived from tosylate and groups derived from mesylate.

Among these, the -Br and -I groups are preferred.

Examples of the boron derivative functional groups include a boric group represented by the formula -B(OH)₂, borate groups and borane groups.

As the borate groups, are preferred groups represented by the formula -B(OR¹⁴) (OR¹⁵) and groups represented by the formula -B(OR¹⁶O).

Examples of preferable groups as the borate groups of such a structure include groups derived from products by esterification of an alcohol having 1 to 6 carbon atoms, an ethanediol such as pinacol, propanediol, or an ortharomatic diol such as 1,2-dihydroxybenzene with its corresponding boric acid.

As the borane groups, are preferred groups represented by the formula -BR¹⁹R²⁰.

R¹⁹ and R²⁰ in the borane groups are, independently of each other, an alkyl group which has 1 to 6 carbon atoms and may be substituted.

As specific preferable examples of the carbazole skeletal monomer and fluorene skeletal monomer used in the Suzuki's method, may be mentioned a compound represented by the following formula (C) for the carbazole skeletal monomer and compounds represented by the following formulae (D) and (E) for the fluorene skeletal monomer.

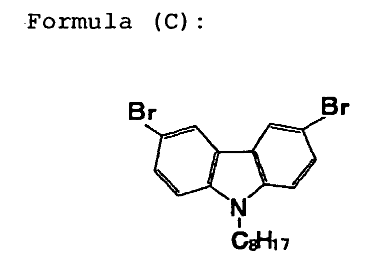

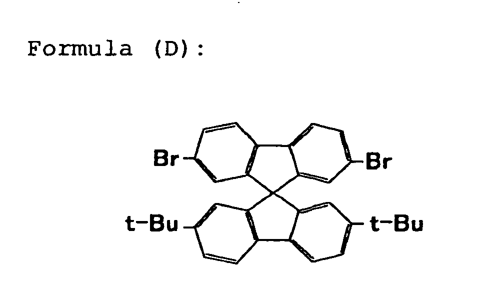

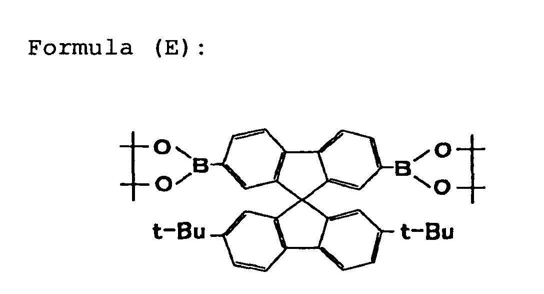

As the reaction solvent, may be suitably used that usable in the Suzuki's method for forming the first conjugated polymer.

As specific preferable examples of the reaction solvent, may be mentioned those preferably used in the Suzuki's method for forming the first conjugated polymer.

The amount of the reaction solvent used varies according to the kinds of the monomers used in the reaction, but is generally a proportion that the total concentration of the monomers used in the reaction amounts to 5 to 30 % by mass.

As the basic compound, may be suitably used that usable in the Suzuki's method for forming the first conjugated polymer.

As the amount of the basic compound used, may be suitably adopted the same amount as that mentioned as the amount used in the Suzuki's method for forming the first conjugated polymer.

As the palladium catalyst, may be suitably used that usable in the Suzuki's method for forming the first conjugated polymer.

As the amount of the palladium catalyst used, may be suitably adopted the same amount as that mentioned as the amount used in the Suzuki's method for forming the first conjugated polymer.

As the reaction temperature, may be suitably adopted the same temperature as that mentioned as the reaction temperature in the Suzuki's method for forming the first conjugated polymer.

As the reaction time, may be suitably adopted the same time as that mentioned as the reaction time in the Suzuki's method for forming the first conjugated polymer.

The reaction product obtained by the polymerization process according to the Suzuki's method is preferably subjected to a post treatment that a low-molecular weight component is removed by, for example, preparative gel permeation chromatography. An organic EL device still higher in luminous efficiency can be provided by conducting such a post treatment.

The polymer for forming an organic EL device composed of such a second conjugated polymer as described above is used in formation of an organic EL device as a material for forming a functional organic layer such as a luminescent layer or charge transport layer by using it singly or together with, for example, a luminescent material having phosphorescent property.

When the polymer for forming an organic EL device is used singly in formation of an organic EL device as a material for forming a functional organic layer, any additive such as an electron transporting low-molecular compound may be added to the polymer for forming an organic EL device as needed.

Examples of the electron transporting low-molecular compound include metal complexes such as tris(8-hydroxyquinolino)aluminum (Alq3), oxadiazole compounds such as 2-(4-biphenyl)-5-(4-tert-butylphenyl)-1,3,4-oxadiazole (PBD) and triazole compounds such as 1-phenyl-2-biphenyl-5-tert-butylphenyl-1,3,4-triazole (TAZ). Oxadiazole compounds such as 2-(4-biphenyl)-5-(4-tert-butylphenyl)-1,3,4-oxadiazole (PBD) are particularly preferably used.

A proportion of the electron transporting low-molecular compound contained is preferably 10 to 40 parts by mass per 100 parts by mass of the polymer for forming an organic EL device.

The polymer for forming an organic EL device is generally used as a material for forming a functional organic layer in a state of a polymer solution for forming an organic EL device by dissolving it in a proper organic solvent. This polymer solution is applied to a surface of a substrate, on which a functional organic layer should be formed, and the resultant coating film is subjected to a treatment for removing the organic solvent, whereby the functional organic layer in the organic EL device can be formed.

The functional organic layer thus obtained can be provided as a layer functioning as a luminescent layer. Alternatively, it can also be provided as a layer functioning as a charge transport layer (hole transport layer or electron transport layer).

No particular limitation is imposed on the organic solvent for preparing the polymer solution for forming an organic EL device so far as it can dissolve the second conjugated polymer making up the polymer for forming an organic EL device to be used. Specific examples thereof include halogenated hydrocarbons such as chloroform, chlorobenzene and tetrachloroethane, amide solvents such as dimethylformamide and N-methylpyrrolidone, cyclohexanone, ethyl lactate, propylene glycol methyl ethyl acetate, ethyl ethoxypropionate, and methyl amyl ketone. These organic solvents may be used either singly or in any combination thereof.

Among these, that having a proper evaporation rate, specifically, an organic solvent having a boiling point of about 70 to 200°C is preferably used in that a thin film having a uniform thickness can be obtained.

A proportion of the organic solvent used varies according to the kind of the second conjugated polymer. However, it is generally a proportion that the concentration of the second conjugated polymer amounts to 0.5 to 10% by mass.

As a means for applying the polymer solution, may be used, for example, a spin coating method, dipping method, roll coating method, ink-jet method or printing method.

No particular limitation is imposed on the thickness of the functional organic layer formed. However, it is generally selected within a range of 10 to 200 nm, preferably 30 to 100 nm.

According to such a polymer for forming an organic EL device, an organic EL device that can achieve light emission high in luminous efficiency and stable even during continuous driving can be provided. In addition, the functional organic layer can be easily formed by the wet method such as ink-jet method.

### <Polymer Composition for Organic EL device>

The polymer composition for organic EL devices according to the present invention comprises a polymer component composed of the above-described polymer for forming an organic EL device, and a complex component that is a triplet luminescent material.

As an iridium complex compound making up the complex component, may be used a complex compound of iridium with a nitrogen atom-containing aromatic compound such as phenylpyridine, phenylpyrimidine, bipyridyl, 1-phenylpyrazole, 2-phenylquinoline, 2-phenylbenzothiazole, 2-phenyl-2-oxazoline, 2,4-diphenyl-1,3,4-oxadiazole, 5-phenyl-2-(4-pyridyl)-1,3,4-oxadiazole or a derivative thereof.

As specific examples of such an iridium complex compound, may be mentioned compounds represented by the following general formulae (3) to (5): 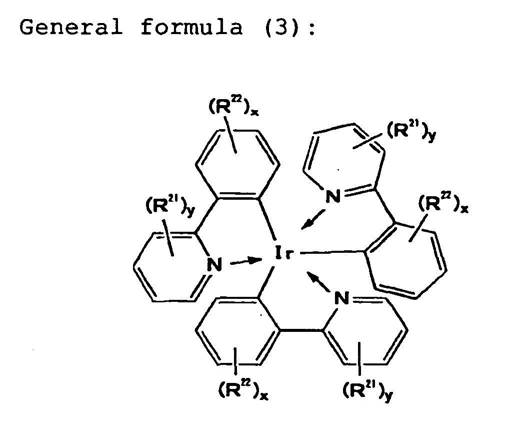 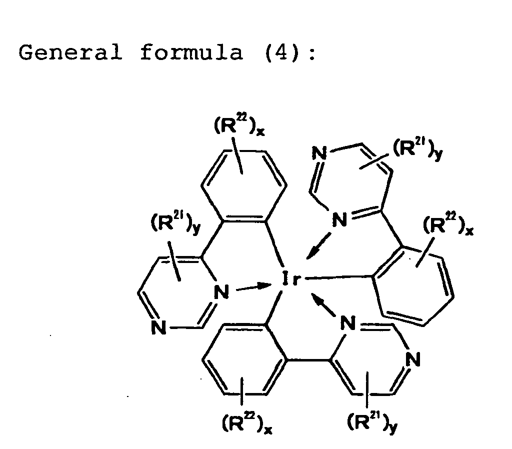 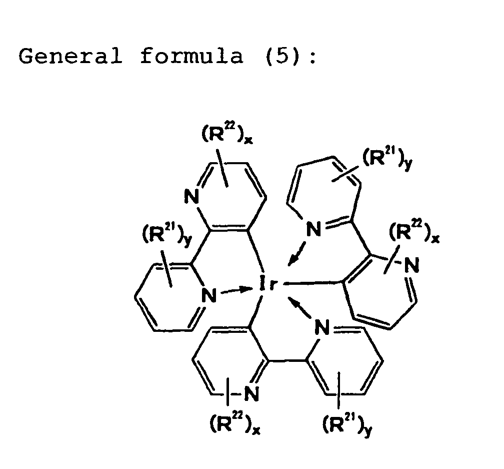 wherein R²¹ and R²² are, independently of each other, a substituent composed of a fluorine atom, alkyl group or aryl group and may be the same or different from each other, x is an integer of 0 to 4, and y is an integer of 0 to 4.

In the above-described formulae (3) to (5), specific examples of the alkyl group related to the substituent R²¹ or R²² include methyl, ethyl, isopropyl, t-butyl, n-butyl, isobutyl, hexyl and octyl groups.

Specific examples of the aryl group include phenyl, tolyl, xylyl, biphenyl and naphthyl groups.

Among the above-described compounds, the iridium complex compound (hereinafter referred to as "specific iridium complex compound") represented by the general formula (3) is preferably used.

The specific iridium complex compound is generally synthesized by reacting a compound represented by the following general formula (6) with a compound represented by the following general formula (7) in the presence of a polar solvent. However, it is important that the content of a specific impurity compound represented by the following general formula (8), which is formed in this synthesis, be at most 1,000 ppm. 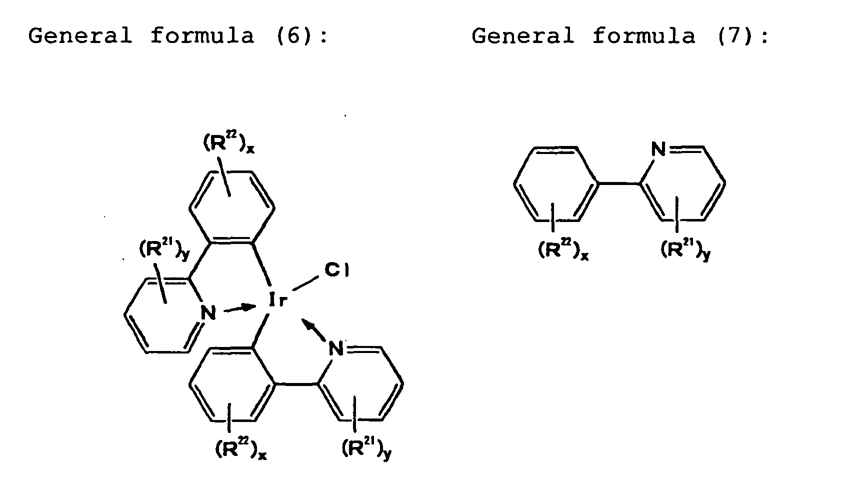 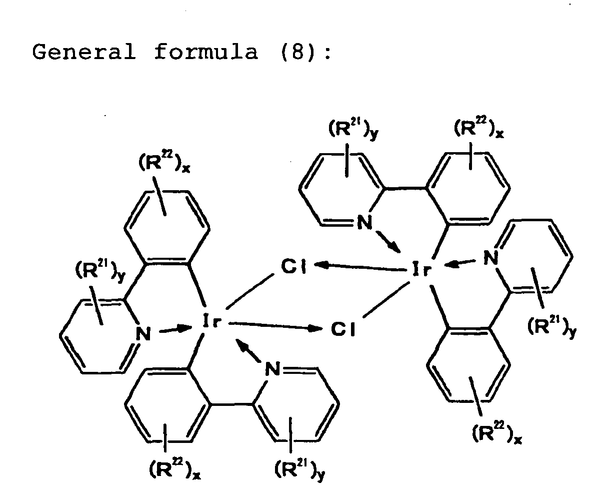 wherein R²¹ and R²² have the same meanings as defined in the general formula (3), x is an integer of 0 to 4, and y is an integer of 0 to 4.

The specific iridium complex compound in which the content of the specific impurity compound is at most 1,000 ppm can be obtained by purifying the reaction product by the above-described synthetic reaction.

If the content of the specific impurity compound in the specific iridium complex compound exceeds 1,000 ppm, the light emitting performance that the specific iridium complex compound has is impaired, and so it is difficult to provide an organic EL device high luminous luminance.

A proportion of the complex component in the polymer composition for organic EL devices according to the present invention is preferably 0.1 to 30 parts by mass, more preferably 0.5 to 10 parts by mass per 100 parts by mass of the polymer component. If this proportion is lower than 0.1 parts by mass, it may be difficult in some cases to achieve sufficient light emission. If the proportion exceeds 30 parts by mass on the other hand, a concentration quenching phenomenon that the brightness of light emission is rather reduced due to the excess proportion of the complex component may occur in some cases. It is hence not preferable to use the complex component in such a high proportion.

Any additive such as an electron transporting low-molecular compound may be added to the polymer composition for organic EL devices according to the present invention as needed.

Examples of the electron transporting low-molecular compound include metal complexes such as tris(8-hydroxyquinolino)aluminum (Alq3), oxadiazole compounds such as 2-(4-biphenyl)-5-(4-tert-butylphenyl)-1,3,4-oxadiazole (PBD) and triazole compounds such as 1-phenyl-2-biphenyl-5-tert-butylphenyl-1,3,4-triazole (TAZ). Oxadiazole compounds such as 2-(4-biphenyl)-5-(4-tert-butylphenyl)-1,3,4-oxadiazole (PBD) are particularly preferably used.

A proportion of the electron transporting low-molecular compound contained is preferably 10 to 40 parts by mass per 100 parts by mass in total of the polymer component and complex component.

The polymer composition for organic EL devices according to the present invention is generally prepared as a composition solution by dissolving the polymer component composed of the polymer for forming an organic EL device and the complex component in a proper organic solvent. This composition solution is applied to a surface of a substrate, on which a functional organic layer should be formed, and the resultant coating film is subjected to a treatment for removing the organic solvent, whereby the functional organic layer in the organic EL device can be formed.

The functional organic layer thus obtained can be provided as a layer functioning as a luminescent layer. Alternatively, it can also be provided as a layer functioning as a charge transport layer (hole transport layer or electron transport layer).

No particular limitation is imposed on the organic solvent for preparing the composition solution so far as it can dissolve the polymer component and complex component used. For example, those usable for preparing the solution of the polymer for forming an organic EL device in the case where the second conjugated polymer is used singly as the material for forming the functional organic layer may be suitably used.

A proportion of the organic solvent used varies according to the kinds of the polymer component and complex component. However, it is generally a proportion that the total concentration of the polymer component and complex component in the resulting composition solution amounts to 0.5 to 10% by mass.

As a means for applying the composition solution, may be used, for example, a spin coating method, dipping method, roll coating method, ink-jet method or printing method.

No particular limitation is imposed on the thickness of the functional organic layer formed. However, it is generally selected within a range of 10 to 200 nm, preferably 30 to 100 nm.

According to such a polymer composition for organic EL devices, an organic EL device that can achieve light emission high in luminous efficiency and stable even during continuous driving can be provided. In addition, the functional organic layer can be easily formed by the wet method such as ink-jet method.

### <Organic EL Device>

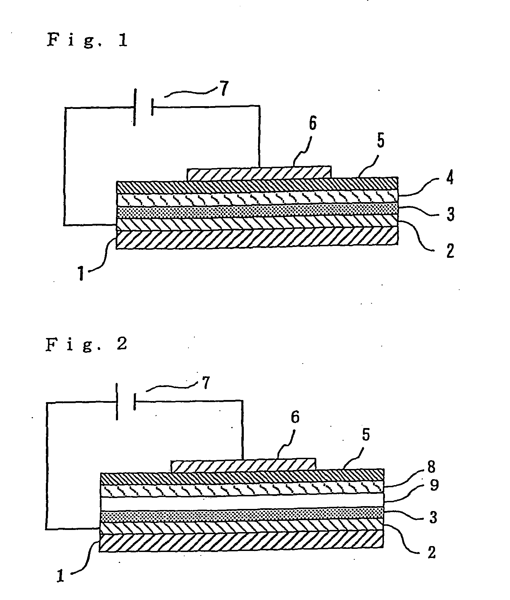

Fig. 1 is a cross-sectional view illustrating the construction of an exemplary organic EL device according to the present invention.

In the organic EL device (hereinafter also referred to as "organic EL device (1)" of the embodiment illustrated in Fig. 1, an anode 2 that is an electrode supplying a hole is provided on a transparent substrate 1. A hole injection and transport layer 3 is provided on this anode 2. A luminescent layer 4 is provided on the hole injection and transport layer 3, and an electron injection layer 5 is provided on the luminescent layer 4. A cathode 6 that is an electrode supplying an electron is provided on this electron injection layer 5. The anode 2 and cathode 6 are electrically connected to a DC power source 7.

In the above-described organic EL device (1), a glass substrate, transparent resin substrate, quartz glass substrate or the like may be used as the transparent substrate 1.

As a material for forming the anode 2, is preferably used a transparent material having a work function as high as, for example, at least 4 eV. In the present invention, the work function means the magnitude of minimum work required to take out an electron from a solid into a vacuum. As the anode 2, may be used, for example, an ITO (indium tin oxide) film, tin oxide (SnO₂) film, copper oxide (CuO) film or zinc oxide (ZnO) film.

The thickness of the anode 2 varies according to the kind of the material used. However, it is generally 10 to 1,000 nm, preferably 50 to 200 nm.

The hole injection and transport layer 3 is provided for efficiently supplying a hole to the luminescent layer 4 and has a function of receiving the hole from the anode 2 and transporting it to the luminescent layer 4.

As a material for forming the hole injection and transport layer 3, may be used, for example, a charge injecting and transporting material such as poly(3,4-ethylenedioxythiophene)-polystyrenesulfonate.

The thickness of the hole injection and transport layer 3 is, for example, 10 to 200 nm.

The luminescent layer 4 is a layer having a function of bonding an electron to a hole to emit the bond energy thereof as light and is formed by the polymer composition for organic EL devices according to the present invention or polymer for forming an organic EL device according to the present invention.

No particular limitation is imposed on the thickness of the luminescent layer 4. However, it is generally selected within a range of 2 to 500 nm.

The electron injection layer 5 is a layer having a function of receiving an electron from the cathode 6 and transporting it to the luminescent layer 4. As a material for forming the electron injection layer 5, is preferably used a co-deposition system (BPCs) of bathophenanthroline material and cesium. Besides, lithium fluoride, magnesium fluoride, strontium oxide or the like may also be used.

The thickness of the electron injection layer 5 is, for example, 0.1 to 100 nm.

As a material for forming the cathode 6, is used a material having a work function as low as, for example, at most 4 eV. Specific examples of the material usable for forming the cathode 6 include metal films composed of aluminum, calcium, magnesium or indium and alloy films of these metals.

The thickness of the cathode 6 varies according to the kind of the material used. However, it is generally 10 to 1,000 nm, preferably 50 to 200 nm.

In the present invention, the organic EL device (1) is produced, for example, in the following manner.

An anode 2 is first formed on a transparent substrate 1.

As a method for forming the anode 2, may be used a vacuum deposition method, sputtering method or the like. Alternatively, a commercially available material that for example, an ITO film has been formed on the surface of a transparent substrate such as a glass substrate may also be used.

A hole injection and transport layer 3 is formed on the anode 2 formed in such a manner.

Specifically, as a method for forming the hole injection and transport layer 3, may be used a method in which a charge injecting and transporting material is dissolved in a proper organic solvent, thereby preparing a solution for forming a hole injection and transport layer, this hole injection and transport layer-forming solution is applied to the surface of the anode 2, and the resultant coating film is subjected to a treatment for removing the organic solvent, thereby forming the hole injection and transport layer 3.

A composition solution composed of the polymer composition for organic EL devices according to the present invention or a polymer solution composed of the polymer for forming an organic EL device according to the present invention is then used as a luminescent layer-forming solution to apply this luminescent layer-forming solution on to the hole injection and transport layer 3, and the resultant coating film is heat-treated, thereby forming a luminescent layer 4.

As a method for applying the luminescent layer-forming solution, may be used a spin coating, dipping, ink-jet or printing method.

An electron injection layer 5 is formed on the luminescent layer 4 thus formed, and a cathode 6 is formed on the electron injection layer 5, thereby obtaining the organic EL device (1) having the structure illustrated in Fig. 1.

In the above-described process, as a method for forming the electron injection layer 5, may be used a dry method such as a vacuum deposition method or a wet method that an electron injecting material is dissolved in a proper solvent, and the solution is then applied by a spin coating method, dipping method, ink-jet method, printing method or the like and dried.

As a method for forming the cathode 6, may be used a dry method such as a vacuum deposition method.

In the above-described organic EL device (1), when DC voltage is applied between the anode 2 and the cathode 6 by the DC power source 7, the luminescent layer 4 emits light. This light is emitted to the outside through the hole injection and transport layer 3, anode 2 and transparent substrate 1.

According to the organic EL device (1) of such an structure, high luminous luminance is achieved, and moreover stable light emission is achieved even during continuous driving, since the luminescent layer 4 is formed by the polymer composition for organic EL devices according to the present invention or the second conjugated polymer that is the polymer for forming an organic EL device according to the present invention.

Fig. 2 is a cross-sectional view illustrating the construction of another exemplary organic EL device according to the present invention.

In the organic EL device (hereinafter also referred to as "organic EL device (2)" of the embodiment illustrated in Fig. 2, an anode 2 that is an electrode supplying a hole is provided on a transparent substrate 1. A hole injection and transport layer 3 is provided on this anode 2. A luminescent layer 9 is provided on the hole injection and transport layer 3, a hole blocking layer 8 is provided on the luminescent layer 9, and an electron injection layer 5 is provided on the hole blocking layer 8. A cathode 6 that is an electrode supplying an electron is provided on this electron injection layer 5. The anode 2 and cathode 6 are electrically connected to a DC power source 7.

The luminescent layer 9 has the same structure as in the luminescent layer 4 in the organic EL device (1) except that the layer is formed by the polymer composition for organic EL devices according to the present invention, which contains the second conjugated polymer as the polymer component, or the second conjugated polymer that is the polymer for forming an organic EL device according to the present invention.

No particular limitation is imposed on the thickness of the luminescent layer 9. However, it is generally selected within a range of 5 to 200 nm.

The hole blocking layer 8 is a layer having a function of inhibiting the hole supplied to the luminescent layer 9 through the hole injection and transport layer 3 from penetrating into the electron injection layer 5 to accelerate recombination of the hole with the electron in the luminescent layer 9, thereby improving luminous efficiency.

As a material for forming the hole blocking layer 8, may be preferably used, for example, 2,9-dimethyl-4,7-diphenyl-1,10-phenanthroline (bathocuproine: BCP) represented by the following formula (F) or 1,3,5-tri(phenyl-2-benzimidazolyl)benzene (TPBI) represented by the following formula (G).

The thickness of the hole blocking layer 8 is, for example, 10 to 30 nm.

In the organic EL device (2), the components having the same reference numerals as those in the organic EL device (1) have the same structures as in the organic EL device (1).

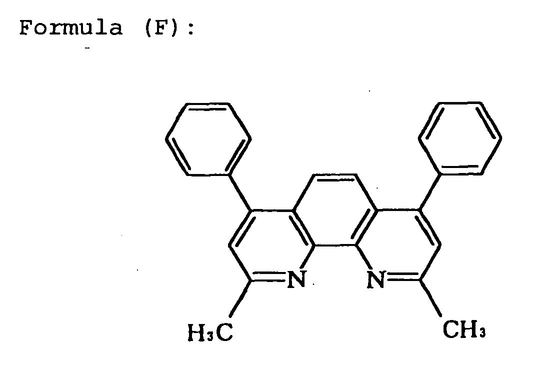

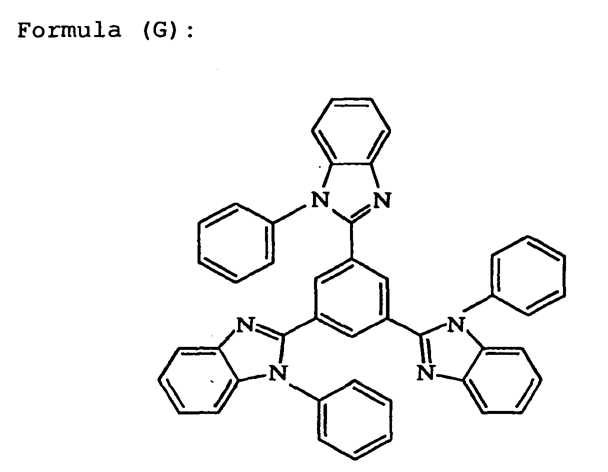

In the present invention, the organic EL device (2) is produced, for example, in the following manner.

An anode 2 is first formed on a transparent substrate 1. A hole injection and transport layer 3 is formed on the anode 2.

A composition solution composed of the polymer composition for organic EL devices according to the present invention, which contains the second conjugated polymer as the polymer component, or a polymer solution composed of the second conjugated polymer that is the polymer for forming an organic EL device is then used as a luminescent layer-forming solution and this luminescent layer-forming solution is applied on to the hole injection and transport layer 3, and the resultant coating film is heat-treated, thereby forming a luminescent layer 9.

As a method for applying the luminescent layer-forming solution, may be used a spin coating, dipping, ink-jet or printing method.

A hole blocking layer 8 is formed on the luminescent layer 9 thus formed, an electron injection layer 5 is formed on the hole blocking layer 8, and a cathode 6 is then formed on the electron injection layer 5, thereby obtaining the organic EL device (2) having the structure illustrated in Fig. 2.

In the above-described process, as a method for forming the hole blocking layer 8, may be used a dry method such as a vacuum deposition method.

In the above-described organic EL device (2), when DC voltage is applied between the anode 2 and the cathode 6 by the DC power source 7, the luminescent layer 4 emits light. This light is emitted to the outside through the hole injection and transport layer 3, anode 2 and transparent substrate 1.

According to the organic EL device (2) of such an structure, high luminous luminance is achieved, and moreover stable light emission is achieved even during continuous driving, since the luminescent layer 9 is formed by the polymer composition for organic EL devices according to the present invention, which contains the second conjugated polymer as the polymer component, or the second conjugated polymer that is the polymer for forming an organic EL device according to the present invention.

In addition, the hole blocking layer 8 is provided, whereby combination of a hole injected from the anode 2 with an electron injected from the cathode 6 is realized at high efficiency. As a result, high luminous luminance and luminous efficiency are achieved.

The present invention will hereinafter be described specifically by the following Examples. However, the present invention is not limited thereto.

### «Examples on First Conjugated Polymer»

### Synthesis Example 1-1:

### (Synthesis of Carbazole Compound (1-1))

A solution with 100 g (626 mmol) of bromine dissolved in 150 ml of acetic acid was added dropwise to a system with 50 g (256 mmol) of N-ethylcarbazole dissolved in 800 ml of acetic acid over 1 hour while cooling by a water bath. Thereafter, the resultant mixture was stirred for 6 hours. The resultant reaction mixture was then poured into a great amount of water, precipitate formed is separated by filtration, the precipitate is diffused in a great amount of water and filtered again, and the precipitate thus obtained is dried at 50°C under reduced pressure to completely dry it, thereby obtaining 87.8 g (248 mmol; yield: 97.2%) of N-ethyldibromocarbazole (hereinafter referred to as "Carbazole Compound (1-1)") as a white solid.

### Synthesis Example 1-2:

### (Synthesis of Fluorene Compound (1-1))

After a system with 20 g (0.12 mmol) of fluorene dissolved in 60 ml of tetrahydrofuran was cooled to -78°C by means of an acetone-dry ice bath under a nitrogen atmosphere, 80 ml (0.128 mol) of 1.6 M n-butyllithium was added dropwise to this system, and the resultant mixture was stirred for 1 hour, 18 ml (0.128 mol) of hexyl bromide was further added dropwise, and stirring was conducted until orrange slurry turned into a red solution, further a yellowish brown solution while cooling by means of a water bath in place of the acetone-dry ice bath. After the yellowish brown solution thus obtained was then cooled to -78°C by means of an acetone-dry ice bath, 90 ml (0.144 mol) of 1.6 M n-butyllithium was added dropwise to this solution, and the resultant mixture was stirred for 1 hour. Thereafter, 24 ml (0.171 mol) of hexyl bromide was added dropwise, and stirring was conducted for 8 hours while cooling by means of a water bath in place of the acetone-dry ice bath. The resultant reaction mixture is poured into 1.5 liters of water to take out an organic layer. A chloroform solution obtained by subjecting a water layer to an extracting treatment 3 times with chloroform was added to the organic layer. After the organic layer solution, with which the chloroform solution had been mixed, was washed with saturated saline and dried over anhydrous magnesium sulfate, the solvent was distilled off under reduced pressure to obtain a yellowish brown oil. This oil was heated under reduced pressure, thereby obtaining pure dihexylfluorene from which unreacted hexyl bromide and an ether as a by-product were removed.

The thus-obtained dihexylfluorene (0.12 mol) and 200 mg (1.23 mmol) of iron(III) chloride were added to 500 ml of chloroform, and this system is cooled in a light-screened state by an ice bath. After 38.4 g (0.24 mol) of bromine was then added dropwise to this system over 20 minutes, the system was stirred for 4 hours while leaving to stand to raise its temperature to room temperature. The resultant reaction mixture was then washed with water, an aqueous solution of sodium thiosulfate, water and saturated saline in this order and dried over anhydrous magnesium sulfate. The solvent was then distilled off under reduced pressure, thereby obtaining 51.4 g (0.1 mol; yield: 87.0%) of dihexyldibromofluorene as a yellowish brown oil. The oil was solidified with time.

After a solution with 10 g (20.3 mmol) of the thus-obtained dihexylbibromofluorene dissolved in 50 ml of tetrahydrofuran under a nitrogen atmosphere was cooled to -78°C by means of an acetone-dry ice bath, 30 ml (48 mmol) of 1.6 M hexane solution of n-butyllithium was added dropwise to this system, and the mixture was stirred for 1 hour. After 13 ml (62.45 mmol) of 2-isopropoxy-4,4,5,5-tetramethyl-1,3,2-dioxaborane was then added dropwise to this system, the resultant mixture was stirred for 8 hours while raising the temperature of the system to room temperature by removing the bath. After 100 ml of 2 M hydrochloric acid was added to the resultant reaction mixture, and the mixture was stirred for 30 minutes, it was poured into 300 ml of water, and an extracting treatment was conducted 3 times with ether. After the resultant ether solution was then dried over anhydrous magnesium sulfate, the ether was distilled off under reduced pressure, thereby obtaining a borate group-containing Fluorene Compound (1-1) represented by the formula (B).

### Preparation Example 1-1 of Polymer: (Yamamoto's method)

Under a nitrogen atmosphere, 25 ml of tetrahydrofuran was added to 1 g (3.64 mmol) of bis(1,5-cyclooctadienyl)nickel and 568 mg (3.64 mmol) of 2,2'-bipyridyl, 0.49 ml (4 mmol) of 1,5-cyclooctadiene was added to this system, and the resultant mixture was refluxed to obtain a nickel solution.

Under a nitrogen atmosphere, 1.8 mmol of Carbazole Compound (1-1) and 1.8 mmol of Fluorene Compound (1-1) were dissolved in 40 ml of tetrahydrofuran, thereby obtaining a dibromo compound-containing solution.

The dibromo compound-containing solution was heated to 60°C and quickly added dropwise to the nickel solution by cannulation. After the resultant mixed solution was refluxed for 6 hours, the metal was separated by filtration. The resultant residue obtained by distilling the filter paper under reduced pressure was dissolved in a small amount of tetrahydrofuran, and the solution was poured into a great amount of methanol, thereby obtaining precipitate of a crude polymer.

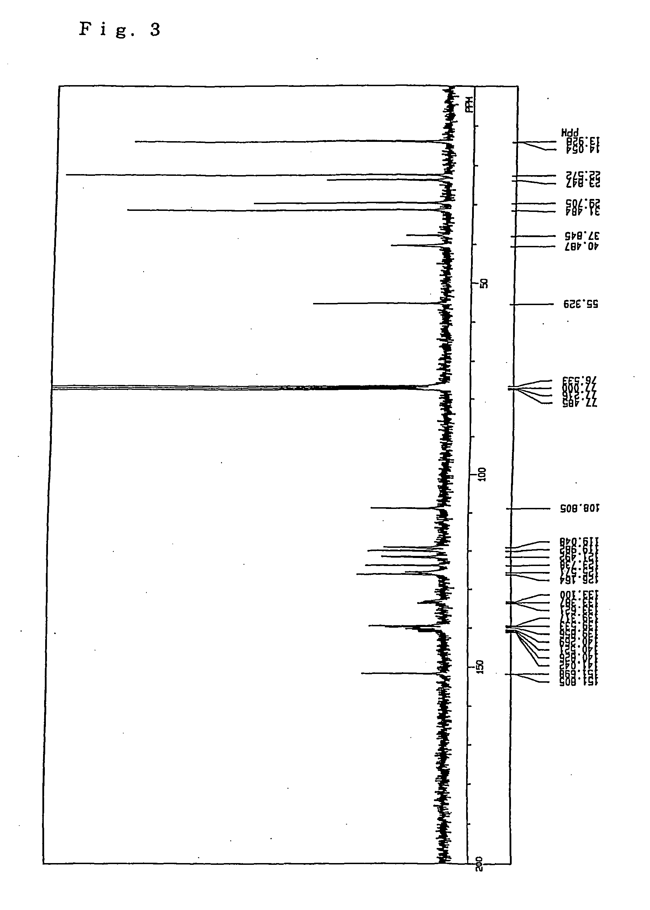

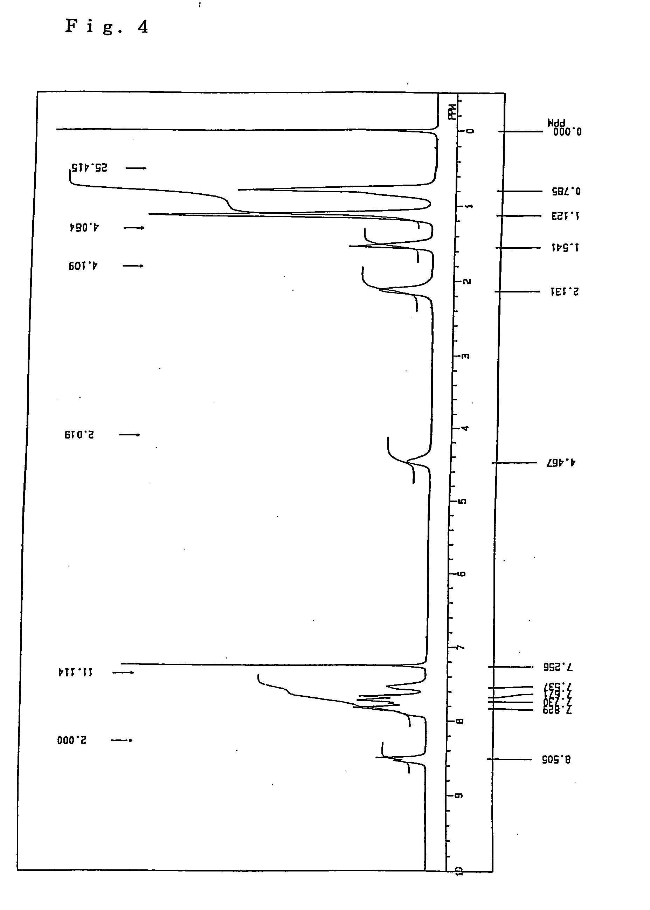

The results obtained by conducting NMR measurement on the crude polymer thus obtained are illustrated in Figs. 3 and 4. As illustrated in Figs. 4, the spectrum of a compound, in which the halogen atoms in Carbazole Compound (1-1) and Fluorene Compound (1-1) have been hydrogenated, was a broadened spectrum.

After the crude polymer thus obtained was dissolved in chloroform and washed 3 times with a solution obtained by adjusting the pH of an aqueous solution of ethylenediaminetetraacetic acid (EDTA) to 7 with aqueous ammonia, once with an aqueous solution of ethylenediaminetetraacetic acid, once with diluted hydrochloric acid and lastly once with ultrapure water, the solvent was distilled off under reduced pressure. The resultant residue was dissolved in a small amount of tetrahydrofuran, and the solution was poured into a great amount of methanol, thereby obtaining Polymer (1-1).

Polymer (1-1) thus obtained was subjected to NMR measurement. As a result, it was identified that this Polymer (1-1) is a random copolymer which has the carbazole structural unit (1) that R¹ in the general formula (1-a) is an ethyl group, and both m and n are 0, and the fluorene structural unit that R⁴ in the general formula (1-b) is a hexyl group, and both p and q are 0, and in which a ratio of the number of carbazole structural units to the number of fluorene structural units is 1:1.

The resultant Polymer (1-1) was subjected to molecular weight measurement by gel permeation chromatography. As a result, the weight average molecular weight thereof was 30,000 in terms of polystyrene, and a ratio Mw/Mn was 8.

### Preparation Example 1-2 of Polymer: (Suzuki's method)

Under a nitrogen atmosphere, 25 ml of tetrahydrofuran and 10 ml of ethanol were added to 2 mmol of Carbazole Compound (1-1) and 2 mmol of Fluorene Compound (1-1), 20 ml of a 1 M aqueous solution of potassium carbonate was added to this system, and the mixture was refluxed. A solution with 50 mg of tetrakis-(triphenylphosphine)palladium dissolved in 5 ml of a mixed solvent of toluene/tetrahydrofuran was added dropwise to the resultant solution, and the resultant mixture was refluxed for 24 hours. After the resultant reaction mixture was cooled, it was filtered, the resultant residue was refluxed for 2 hours in diluted hydrochloric acid, the resultant solution was filtered, and a solid thus obtained was dissolved in a small amount of toluene. This solution was poured into a great amount of methanol, thereby obtaining Polymer (1-2) as precipitate.

Polymer (1-2) thus obtained was subjected to NMR measurement. As a result, it was identified that this Polymer (1-2) is an alternating copolymer that R¹ in the general formula (b) is an ethyl group, both m and n are 0, R⁴ is a hexyl group, and both p and q are 0.

The resultant Polymer (1-2) was subjected to molecular weight measurement by gel permeation chromatography. As a result, the weight average molecular weight thereof was 55,000 in terms of polystyrene, and a ratio Mw/Mn was 5.7.

### Preparation Example 1-3 of Polymer:

Polymer (1-2) obtained in Preparation Example 1-2 of Polymer was dissolved in toluene, acetone was added to the toluene solution in such a manner that a ratio of toluene to acetone is 1:1, and an insoluble component deposited thereby was separated by filtration. The filtrate was then poured into a great amount of acetone, thereby obtaining Polymer (1-3) as precipitate.

Polymer (1-3) thus obtained was subjected to molecular weight measurement by gel permeation chromatography. As a result, the weight average molecular weight thereof was 5,700 in terms of polystyrene, and a ratio Mw/Mn was 1.2.

### Preparation Example 1-4 of Polymer:

The insoluble component separated by filtration in Preparation Example 1-3 of Polymer was dissolved in toluene, acetone was added to the toluene solution in such a manner that a ratio of toluene to acetone is 1.1:1, and an insoluble component deposited thereby was separated by filtration. The filtrate was then poured into a great amount of acetone, thereby obtaining Polymer (1-4) as precipitate.

Polymer (1-4) thus obtained was subjected to molecular weight measurement by gel permeation chromatography. As a result, the weight average molecular weight thereof was 34,000 in terms of polystyrene, and a ratio Mw/Mn was 2.6.

### Preparation Example 1-5 of Polymer:

The insoluble component separated by filtration in Preparation Example 1-4 of Polymer was dissolved in toluene, acetone was added to the toluene solution in such a manner that a ratio of toluene to acetone is 1.5:1, and an insoluble component deposited thereby was separated by filtration. The filtrate was then poured into a great amount of acetone, thereby obtaining Polymer (1-5) as precipitate.

Polymer (1-5) thus obtained was subjected to molecular weight measurement by gel permeation chromatography. As a result, the weight average molecular weight thereof was 81,000 in terms of polystyrene, and a ratio Mw/Mn was 2.2.

### Example 1-1:

### (Preparation of solution of polymer composition for organic EL device)

Cyclohexanone was added to a mixed system of 10 g of Polymer (1-1) and Ir(ppy)₃ (compound that x and y in the general formula (3) are 0) in a proportion of 4 mol% based on Polymer (1-1) in such a manner that the solid concentration amounts to 3 % by mass, and the resultant solution was filtered through a filter having a pore size of 2.52 µm, thereby preparing Composition Solution (1-1) with a polymer composition for organic EL devices dissolved in the organic solvent.

### (Production of organic EL device)

An ITO substrate, in which an ITO film had been formed on a transparent substrate, was provided, and this ITO substrate was subjected to ultrasonic cleaning with a neutral detergent, ultrapure water, isopropyl alcohol, ultrapure water and acetone in that order and then further subjected to ultraviolet-ozone (UV/O₃) cleaning.

A solution of poly(3,4-ethylenedioxythiophene)-polystyrenesulfonate (PEDOT/PSS) was applied on to the cleaned ITO substrate by a spin coating method, and the resultant coating film having a thickness of 65 nm was then dried at 250°C for 30 minutes under a nitrogen atmosphere, thereby forming a hole injection layer.

Composition Solution (1-1) was then applied to the surface of the hole injection layer thus obtained by the spin coating method, and the resultant coating film having a thickness of 75 nm was dried at 150°C for 10 minutes under a nitrogen atmosphere, thereby forming a luminescent layer.

A laminate, in which the hole injection layer and luminescent layer had been laminated on the ITO substrate in that order, was fixed within a vacuum device, and the pressure within the vacuum device was reduced to 1 x 10⁻⁴ Pa or lower to co-deposit bathophenanthroline and cesium (Cs) in a proportion of 3:1 in terms of a molar ratio, thereby forming an electron injection layer.

Aluminum was vapor-deposited on the surface of the electron injection layer to form an aluminum film having a thickness of 1,000 Å. Thereafter, sealing was conducted with a glass material, thereby producing Organic EL Device (1-1).

### (Evaluation of organic EL device)

DC voltage was applied to the resultant Organic EL Device (1-1) using the ITO film as an anode and the aluminum film as a cathode in such a manner that a value of voltage gradually increases, thereby applying an electric field thereto. As a result, it was confirmed that light emission is started from voltage of 8.5 V, and a maximum luminous luminance is 1,100 cd/m².

Further, a luminous luminance (hereinafter referred to as "luminance before heating") when DC voltage of 10 V was applied to Organic EL Device (1-1) to drive it was measured, and a luminous luminance (hereinafter referred to as "luminance after heating") when Organic EL Device (1-1) was subjected to a heat treatment at 150°C for 1 hour, and DC voltage of 10 V was then applied again to Organic EL Device (1-1) to drive it was measured. As a result, it was confirmed that the luminance after heating is the same or similar intensity as the luminance before heating.

### Example 1-2:

Composition Solution (1-2) was obtained in the same manner as in Example 1-1 except that a molecular weight-modified polymer having a weight average molecular weight of 50,000 in terms of polystyrene and an Mw/Mn ratio of 2.5, which had been obtained by subjecting Polymer (1-1) to preparative gel permeation chromatography to remove a low-molecular weight component, was used in place of Polymer (1-1) in the step of preparing the solution of the polymer composition for organic EL devices in Example 1-1. Organic EL Device (1-2) was then produced in the same manner as in Example 1-1 except that Composition Solution (1-2) was used in place of Composition Solution (1-1) in the step of producing the organic EL device.

Organic EL Device (1-2) thus obtained was evaluated by the same method as in Example 1-1. As a result, it was confirmed that light emission is started from voltage of 7.5 V, and a maximum luminous luminance is 1,450 cd/m².

Further, it was confirmed that the luminance after heating in Organic EL Device (1-2) is the same or similar intensity as the luminance before heating.

### Example 1-3:

Composition Solution (1-3) was obtained in the same manner as in Example 1-1 except that Polymer (1-2) was used in place of Polymer (1-1) in the step of preparing the solution of the polymer composition for organic EL devices in Example 1-1. Organic EL Device (1-3) was then produced in the same manner as in Example 1-1 except that Composition Solution (1-3) was used in place of Composition Solution (1-1) in the step of producing the organic EL device.

Organic EL Device (1-3) thus obtained was evaluated by the same method as in Example 1-1. As a result, it was confirmed that light emission is started from voltage of 7.0 V, and a maximum luminous luminance is 1,840 cd/m².

Further, it was confirmed that the luminance after heating in Organic EL Device (1-3) is the same or similar intensity as the luminance before heating.

### Example 1-4:

Composition Solution (1-4) was obtained in the same manner as in Example 1-1 except that Polymer (1-3) was used in place of Polymer (1-1) in the step of preparing the solution of the polymer composition for organic EL devices in Example 1-1. Organic EL Device (1-4) was then produced in the same manner as in Example 1-1 except that Composition Solution (1-4) was used in place of Composition Solution (1-1) in the step of producing the organic EL device.

Organic EL Device (1-4) thus obtained was evaluated by the same method as in Example 1-1. As a result, it was confirmed that light emission is started from voltage of 5.7 V, and a maximum luminous luminance is 980 cd/m².

Further, it was confirmed that the luminance after heating in Organic EL Device (1-4) is the same or similar intensity as the luminance before heating.

### Example 1-5:

Composition Solution (1-5) was obtained in the same manner as in Example 1-1 except that Polymer (1-4) was used in place of Polymer (1-1) in the step of preparing the solution of the polymer composition for organic EL devices in Example 1-1. Organic EL Device (1-5) was then produced in the same manner as in Example 1-1 except that Composition Solution (1-5) was used in place of Composition Solution (1-1) in the step of producing the organic EL device.

Organic EL Device (1-5) thus obtained was evaluated by the same method as in Example 1-1. As a result, it was confirmed that light emission is started from voltage of 6.8 V, and a maximum luminous luminance is 1,530 cd/m².

Further, it was confirmed that the luminance after heating in Organic EL Device (1-5) is the same or similar intensity as the luminance before heating.

### Example 1-6:

Composition Solution (1-6) was obtained in the same manner as in Example 1-1 except that Polymer (1-5) was used in place of Polymer (1-1) in the step of preparing the solution of the polymer composition for organic EL devices in Example 1-1. Organic EL Device (1-6) was then produced in the same manner as in Example 1-1 except that Composition Solution (1-6) was used in place of Composition Solution (1-1) in the step of producing the organic EL device.

Organic EL Device (1-6) thus obtained was evaluated by the same method as in Example 1-1. As a result, it was confirmed that light emission is started from voltage of 7.2 V, and a maximum luminous luminance is 2,100 cd/m².

Further, it was confirmed that the luminance after heating in Organic EL Device (1-6) is the same or similar intensity as the luminance before heating.

### Comparative Example 1-1:

Comparative Organic EL Device (1-1) was produced in the same manner as in Example 1-1 except that Comparative Composition Solution (1-1) obtained by mixing polyvinylcarbazole with 2,9-dimethyl-4,7-diphenyl-1,10-phenanthroline in a proportion of 20 mol% to polyvinylcarbazole, further mixing Ir(ppy)₃ so as to give a content of 1 mol% in the total mole of polyvinylcarbazole and 2,9-dimethyl-4,7-diphenyl-1,10-phenanthroline and adding cyclohexanone in such a manner that the solid concentration amounts to 3 % by mass was used in place of Composition Solution (1-1) in the step of producing the organic EL device.

Comparative Organic EL Device (1-1) thus obtained was evaluated by the same method as in Example 1-1. As a result, it was confirmed that light emission is started from voltage of 9 V, and a maximum luminous luminance is 600 cd/m².

Further, it was confirmed that the luminance after heating in Comparative Organic EL Device (1-1) is 60% of the luminance before heating.

From the results described above, it was confirmed that the composition comprising the polymer component composed of the first conjugated copolymer having the specific carbazole structural unit and the specific fluorene structural unit, and the complex component composed of the iridium complex compound that is a triplet luminescent material is used as a material for forming a luminescent layer, whereby a thin film can be easily formed by the wet method, and an organic EL device that can achieve light emission high in luminous luminance and stable even during continuous driving can be provided.

Since a spectrum derived from Ir(ppy)₃ whose luminescence wavelength is 515 nm was obtained in each of Organic EL Devices (1-1) to (1-6) according to Examples 1-1 to 1-6, it was confirmed that light emission is not achieved from a host polymer related to the polymer component making up each of Composition Solutions (1-1) to (1-6), but energy transfer from the host polymer to Ir (ppy)₃ occurs.

According to the polymer according to the present invention for forming an organic EL device, which is composed of the first conjugated polymer, a thin film can be easily formed by the wet method, and an organic EL device that can achieve light emission high in luminous luminance and stable even during continuous driving can be provided, since the first conjugated polymer has the specific carbazole structural unit and the specific fluorene structural unit.

Since the polymer compositions for organic EL devices according to the present invention contain the conjugated polymer making up the polymer for forming an organic EL device as a polymer component and are composed of this polymer component and the complex component composed of the iridium complex compound that is a triplet luminescent material, a thin film can be easily formed by the wet method, and an organic EL device that can achieve light emission high in luminous luminance and stable even during continuous driving can be provided.

Since the organic EL devices according to the present invention have a functional organic layer formed by the above-described polymer composition for organic EL devices, light emission high in luminous luminance and stable even during continuous driving can be achieved. «Examples on Second Conjugated Polymer»

### Synthesis Example 2-1:

### (Synthesis of Carbazole Compound (2-1))

A system with 3.25 g (10 mmol) of dibromocarbazole and 9.95 g (72 mmol) of potassium carbonate dissolved in 25 ml of dimethylformamide was heated to 50°C and stirred for 30 minutes. Thereafter, 1.93 g (10 mmol) of octyl bromide was added dropwise to this system, and the mixture was then stirred for 24 hours. Ethyl acetate was then added to the resultant reaction slurry, and the reaction slurry was washed with water and saturated saline. It was then dried over anhydrous magnesium sulfate, the solvent was distilled off under reduced pressure, the residue was heated and vacuumized by a vacuum pump, thereby removing unreacted octyl bromide.

The resultant crude product was purified by column chromatography using a mixture of hexane and methylene chloride (mixing ratio: 4:1) as a developing solvent, thereby obtaining 3.927 g (8.99 mmol; yield: 89.9%) of N-octyldibromo-carbazole (hereinafter referred to as "Carbazole Compound (2-1)" represented by the formula (C).

Carbazole Compound (2-1) thus obtained was in an oil state just after preparation, but was changed to a white solid with time.

### Synthesis Example 2-2:

### (Synthesis of Spirofluorene Compound (2-1))

Under a nitrogen atmosphere, 25 g (117 mmol) of bromo-t-butylbenzene, 25 g (140 mmol) of t-butylphenylboric acid and 5 g (4.32 mmol) of tetrakis(triphenylphosphine)palladium were dissolved in 600 ml of toluene, a solution with 63.6 g (600 mmol) of sodium carbonate dissolved in 300 ml of water was added to this system, and the resultant mixed system was stirred at 90°C for 30 hours.

An organic layer in the resultant reaction mixture was washed with saturated saline and dried over anhydrous magnesium sulfate, and the solvent was then distilled off under reduced pressure.

The resultant crude product was treated by column chromatography using chloroform as a developing solvent to remove the catalyst in the vicinity of the origin, thereby obtaining 28.7 g (107.8 mmol; yield: 92.2%) of di-t-butylbiphenyl.

To 150 ml of carbon tetrachloride, were added 39.9 g (150 mmol) of di-t-butylbiphenyl and a catalytic amount of iron(III) chloride. After 26.4 g (165 mmol) of bromine was added dropwise to this system over 30 minutes, the mixture was refluxed for 6 hours. The resultant reaction mixture was washed with an aqueous solution of sodium thiosulfate, water and saturated saline and dried over anhydrous magnesium sulfate. The solvent was distilled off under reduced pressure, and the residue was recrystallized from ethanol, thereby obtaining 39.2 g (113.6 mmol; yield: 75.7%) of bromo-di-t-butylbiphenyl as a white solid.

Under a nitrogen atmosphere, 1.76 g (68.6 mmol) of magnesium was immersed in ether, and a trace amount of dibromoethane was added to initiate a Grignard reaction. A solution with 20.5 g (62.4 mmol) of bromo-di-t-butylbiphenyl dissolved in 31 ml of ether was then added dropwise to this system while suitably heating by a heat gun so as not to break off the Grignard reaction. The system was then refluxed at 40°C for 3 hours to maturate the Grignard reaction mixture.

Under a nitrogen atmosphere, the Grignard reaction mixture cooled to room temperature was then added dropwise to a solution obtained by adding 20 g (56.8 mmol) of dibromofluorene to 300 ml of ether by cannulation. After the resultant mixture was refluxed for 8 hours, an aqueous solution of ammonium chloride was added, and the mixture was stirred for 30 minutes. The resultant organic layer was then washed with water and saturated saline and dried over anhydrous magnesium sulfate. The solvent was distilled off under reduced pressure to obtain an alcohol compound, to which 200 ml of acetic acid and 1 ml of concentrated hydrochloric acid were added, and the mixture was refluxed for 4 hours. The resultant reaction mixture was cooled, crystals deposited were recovered by filtration, the resultant crystals were stirred for 12 hours in hexane to dissolve out impurities, thereby obtaining 16.2 g (27.7 mmol; yield: 44.3%) of 2,7-dibromospirobifluorene (hereinafter referred to as "Spirofluorene Compound (2-1)") represented by the formula (D) as a white solid. Synthesis Example 2-3:

### (Synthesis of Spirofluorene Compound (2-2))

A solution with 10 g (17 mmol) of 2,7-dibromospirobifluorene dissolved in 170 ml of tetrahydrofuran under a nitrogen atmosphere was cooled to -78°C by means of an acetone-dry ice bath, and 22.3 ml (35.7 mmol) of n-butyllithium (1.6 M hexane solution) was added dropwise to the solution, and the resultant mixture was then stirred at - 78°C for 1 hour. After 7.87 ml (38.6 mmol) of 2-isopropoxy-4,4,5,5-tetramethyl-1,3,2-dioxaborane was then added dropwise, the resultant mixture was stirred for 8 hours while raising the temperature of the system to room temperature by removing the bath. Saturated saline was added to the resultant reaction mixture, and the resultant mixture was stirred for 30 minutes. After the resultant organic layer was dried over anhydrous magnesium sulfate, the solvent was distilled off under reduced pressure.

The resultant crude product was recrystallized from methylene chloride/hexane, thereby obtaining a diboric ester (hereinafter referred to as "Spirofluorene Compound (2-2)") of di-t-butylspirofluorene represented by the formula (E) at a yield of 90%.

### Preparation Example 2-1 of Polymer:

Under a nitrogen atmosphere, 25 ml of tetrahydrofuran and 10 ml of ethanol were added to 1.33 mmol of Carbazole Compound (2-1), 0.67 mmol of Spirofluorene Compound (2-1) and 2 mmol of Spirofluorene Compound (2-2), 20 ml of a 1 M aqueous solution of potassium carbonate was added to this system, and the mixture was refluxed. A solution with 50 mg of tetrakis-(triphenylphosphine)palladium dissolved in 5 ml of a mixed solvent of toluene/tetrahydrofuran was added dropwise to the resultant solution, and the resultant mixture was refluxed for 24 hours. After the resultant reaction mixture was cooled, it was filtered, the resultant residue was refluxed for 2 hours in diluted hydrochloric acid, the resultant solution was filtered, and a solid thus obtained was dissolved in a small amount of toluene. This solution was poured into a great amount of methanol, thereby obtaining Polymer (2-1) as precipitate.

Polymer (2-1) thus obtained was a random copolymer that R⁷ in the general formula (c) is an octyl group, both r and s are 0, both t and u are 0, R¹² and R¹³ are both t-butyl group, both v and w are 1, and a ratio of the number c of repeated carbazole structural units to the number d of repeated fluorene structural units is 2.

The resultant Polymer (2-1) was subjected to molecular weight measurement by gel permeation chromatography. As a result, the weight average molecular weight thereof was 50,000 in terms of polystyrene, and a ratio Mw/Mn was 4.8.

### Preparation Example 2-2 of Polymer:

Under a nitrogen atmosphere, 25 ml of tetrahydrofuran and 10 ml of ethanol were added to 0.8 mmol of Carbazole Compound (2-1), 1.2 mmol of Spirofluorene Compound (2-1) and 2.0 mmol of Spirofluorene Compound (2-2), 20 ml of a 1 M aqueous solution of potassium carbonate was added to this system, and the mixture was refluxed. A solution with 50 mg of tetrakis(triphenylphosphine)palladium dissolved in 5 ml of a mixed solvent of toluene/tetrahydrofuran was added dropwise to the resultant solution, and the resultant mixture was refluxed for 24 hours. After the resultant reaction mixture was cooled, it was filtered, the resultant residue was refluxed for 2 hours in diluted hydrochloric acid, the resultant solution was filtered, and a solid thus obtained was dissolved in a small amount of toluene. This solution was poured into a great amount of methanol, thereby obtaining Polymer (2-2) as precipitate.

Polymer (2-2) thus obtained was a random copolymer that R⁷ in the general formula (c) is an octyl group, both r and s are 0, both t and u are 0, R¹² and R¹³ are both t-butyl group, both v and w are 1, and a ratio of the number c of repeated carbazole structural units to the number d of repeated fluorene structural units is 4. Preparation Example 2-3 of Polymer:

The polymer (2-1) obtained in Preparation Example 2-1 of Polymer was dissolved in toluene, acetone was added to the toluene solution in such a manner that a ratio of toluene to acetone is 1:1, and an insoluble component deposited thereby was separated by filtration. The filtrate was then poured into a great amount of acetone, thereby obtaining Polymer (2-3) as precipitate.

Polymer (2-3) thus obtained was subjected to molecular weight measurement by gel permeation chromatography. As a result, the weight average molecular weight thereof was 5,000 in terms of polystyrene, and a ratio Mw/Mn was 1.3.

### Preparation Example 2-4 of Polymer:

The insoluble component separated by filtration in Preparation Example 2-3 of Polymer was dissolved in toluene, acetone was added to the toluene solution in such a manner that a ratio of toluene to acetone is 1.1:1, and an insoluble component deposited thereby was separated by filtration. The filtrate was then poured into a great amount of acetone, thereby obtaining Polymer (2-4) as precipitate.

Polymer (2-4) thus obtained was subjected to molecular weight measurement by gel permeation chromatography. As a result, the weight average molecular weight thereof was 30,000 in terms of polystyrene, and a ratio Mw/Mn was 2.3.

### Preparation Example 2-5 of Polymer:

The insoluble component separated by filtration in Preparation Example 2-4 of Polymer was dissolved in toluene, acetone was added to the toluene solution in such a manner that a ratio of toluene to acetone is 1.5:1, and an insoluble component deposited thereby was separated by filtration. The filtrate was then poured into a great amount of acetone, thereby obtaining Polymer (2-5) as precipitate.

Polymer (2-5) thus obtained was subjected to molecular weight measurement by gel permeation chromatography. As a result, the weight average molecular weight thereof was 80,000 in terms of polystyrene, and a ratio Mw/Mn was 2.1.

### Preparation Example 2-6 of Polymer:

Under a nitrogen atmosphere, 25 ml of tetrahydrofuran and 10 ml of ethanol were added to 2 mmol of Carbazole Compound (2-1) and 2 mmol of Spirofluorene Compound (2-1), 20 ml of a 1 M aqueous solution of potassium carbonate was added to this system, and the mixture was refluxed. A solution with 50 mg of tetrakis-(triphenylphosphine)palladium dissolved in 5 ml of a mixed solvent of toluene/tetrahydrofuran was added dropwise to the resultant solution, and the resultant mixture was refluxed for 24 hours. After the resultant reaction mixture was cooled, it was filtered, the resultant residue was refluxed for 2 hours in diluted hydrochloric acid, the resultant solution was filtered, and a solid thus obtained was dissolved in a small amount of toluene. This solution was poured into a great amount of methanol, thereby obtaining Polymer (2-6) as precipitate.

Polymer (2-6) thus obtained was a copolymer that R⁷ in the general formula (c) is an octyl group, both r and s are 0, both t and u are 0, R¹² and R¹³ are both t-butyl group, both v and w are 1, and a ratio of the number c of repeated carbazole structural units to the number d of repeated fluorene structural units is 1.

### Example 2-1:

### (Preparation of solution of polymer for forming organic EL device)

Cyclohexanone was added to 10 g of Polymer (2-1) in such a manner that the solid concentration amounts to 3 % by mass, and the resultant solution was filtered through a filter having a pore size of 2.52 µm, thereby preparing Polymer Solution (2-1) with the polymer for forming organic EL devices dissolved in the organic solvent.

### (Production of organic EL device)

An ITO substrate, in which an ITO film had been formed on a transparent substrate, was provided, and this ITO substrate was subjected to ultrasonic cleaning with a neutral detergent, ultrapure water, isopropyl alcohol, ultrapure water and acetone in this order and then further subjected to ultraviolet-ozone (UV/O₃) cleaning.

A solution of poly(3,4-ethylenedioxythiophene)-polystyrenesulfonate (PEDOT/PSS) was applied on to the cleaned ITO substrate by a spin coating method, and the resultant coating film having a thickness of 65 nm was then dried at 250°C for 30 minutes under a nitrogen atmosphere, thereby forming a hole injection layer.

Polymer Solution (2-1) as a luminescent layer forming fluid was then applied to the surface of the hole injection layer thus obtained by the spin coating method, and the resultant coating film having a thickness of 75 nm was dried at 150°C for 10 minutes under a nitrogen atmosphere, thereby forming a luminescent layer.

A laminate, in which the hole injection layer and luminescent layer had been laminated on the ITO substrate in that order, was fixed within a vacuum device, and the pressure within the vacuum device was then reduced to 1 x 10⁻⁴ Pa or lower to co-deposit bathophenanthroline and cesium (Cs) in a proportion of 3:1 in terms of a molar ratio, thereby forming an electron injection layer.

Aluminum was vapor-deposited on the surface of the electron injection layer to form an aluminum film having a thickness of 1,000 Å. Thereafter, sealing was conducted with a glass material, thereby producing Organic EL Device (2-1).

### (Evaluation of organic EL device)

DC voltage was applied to the resultant Organic EL Device (2-1) using the ITO film as an anode and the aluminum film as a cathode in such a manner that a value of voltage gradually increases, thereby applying an electric field thereto. As a result, it was confirmed that light emission is started from voltage of 4.8 V, and a maximum luminous luminance is 1,370 cd/m².

Further, a luminous luminance (luminance before heating) when DC voltage of 10 V was applied to Organic EL Device (2-1) to drive it was measured, and a luminous luminance (luminance after heating) when Organic EL Device (2-1) was subjected to a heat treatment at 150°C for 1 hour, and DC voltage of 10 V was then applied again to Organic EL Device (2-1) to drive it was measured. As a result, it was confirmed that the luminance after heating is the same or similar intensity as the luminance before heating.

### Example 2-2:

Organic EL Device (2-2) was produced in the same manner as in Example 2-1 except that a hole blocking layer having a thickness of 10 nm was formed between the luminescent layer and the electron injection layer in the step of producing the organic EL device in Example 2-1.

Specifically, a laminate, in which the hole injection layer and luminescent layer had been laminated on the ITO substrate in that order, was fixed within a vacuum device, and the pressure within the vacuum device was then reduced to 1 x 10⁻⁴ Pa or lower to deposit 2,9-dimethyl-4,7-diphenyl-1,10-phenanthroline (bathocuproine: BCP) represented by the formula (F) on the surface of the luminescent layer, thereby forming the hole blocking layer.

Organic EL Device (2-2) thus obtained was evaluated by the same method as in Example 2-1. As a result, it was confirmed that light emission is started from voltage of 4.2 V, and a maximum luminous luminance is 3,120 cd/m².

Further, it was confirmed that the luminance after heating in Organic EL Device (2-2) is the same or similar intensity as the luminance before heating.

### Example 2-3:

Polymer Solution (2-2) was obtained in the same manner as in Example 2-1 except that Polymer (2-2) was used in place of Polymer (2-1) in the step of preparing the solution of the polymer for forming organic EL devices in Example 2-1.

Organic EL Device (2-3) was then produced in the same manner as in Example 2-2 except that Polymer Solution (2-2) was used in place of Polymer Solution (2-1) in the step of producing the organic EL device in

### Example 2-2.

Organic EL Device (2-3) thus obtained was evaluated by the same method as in Example 2-1. As a result, it was confirmed that light emission is started from voltage of 5.6 V, and a maximum luminous luminance is 1,470 cd/m².

Further, it was confirmed that the luminance after heating in Organic EL Device (2-3) is the same or similar intensity as the luminance before heating.

### Example 2-4:

Polymer Solution (2-3) was obtained in the same manner as in Example 2-1 except that Polymer (2-3) was used in place of Polymer (2-1) in the step of preparing the solution of the polymer for forming organic EL devices in Example 2-1.

Organic EL Device (2-4) was then produced in the same manner as in Example 2-2 except that Polymer Solution (2-3) was used in place of Polymer Solution (2-1) in the step of producing the organic EL device in

### Example 2-2.

Organic EL Device (2-4) thus obtained was evaluated by the same method as in Example 2-1. As a result, it was confirmed that light emission is started from voltage of 4.0 V, and a maximum luminous luminance is 1,900 cd/m².

Further, it was confirmed that the luminance after heating in Organic EL Device (2-4) is the same or similar intensity as the luminance before heating.

### Example 2-5:

Polymer Solution (2-4) was obtained in the same manner as in Example 2-1 except that Polymer (2-4) was used in place of Polymer (2-1) in the step of preparing the solution of the polymer for forming organic EL devices in Example 2-1.

Organic EL Device (2-5) was then produced in the same manner as in Example 2-2 except that Polymer Solution (2-4) was used in place of Polymer Solution (2-1) in the step of producing the organic EL device in

### Example 2-2.

Organic EL Device (2-5) thus obtained was evaluated by the same method as in Example 2-1. As a result, it was confirmed that light emission is started from voltage of 4.0 V, and a maximum luminous luminance is 2,960 cd/m².

Further, it was confirmed that the luminance after heating in Organic EL Device (2-5) is the same or similar intensity as the luminance before heating.

### Example 2-6:

Polymer Solution (2-5) was obtained in the same manner as in Example 2-1 except that Polymer (2-5) was used in place of Polymer (2-1) in the step of preparing the solution of the polymer for forming organic EL devices in Example 2-1.

Organic EL Device (2-6) was then produced in the same manner as in Example 2-2 except that Polymer Solution (2-5) was used in place of Polymer Solution (2-1) in the step of producing the organic EL device in

### Example 2-2.

Organic EL Device (2-6) thus obtained was evaluated by the same method as in Example 2-1. As a result, it was confirmed that light emission is started from voltage of 4.2 V, and a maximum luminous luminance is 4,060 cd/m².

Further, it was confirmed that the luminance after heating in Organic EL Device (2-6) is the same intensity as the luminance before heating.

### Example 2-7:

Polymer Solution (2-6) was obtained in the same manner as in Example 2-1 except that Polymer (2-6) was used in place of Polymer (2-1) in the step of preparing the solution of the polymer for forming organic EL devices in Example 2-1.

Organic EL Device (2-7) was then produced in the same manner as in Example 2-1 except that Polymer Solution (2-6) was used in place of Polymer Solution (2-1) in the step of producing the organic EL device in

### Example 2-1.

Organic EL Device (2-7) thus obtained was evaluated by the same method as in Example 2-1. As a result, it was confirmed that light emission is started from voltage of 8.6 V, and a maximum luminous luminance is 735 cd/m².

### Example 2-8:

Organic EL Device (2-8) was produced in the same manner as in Example 2-2 except that Polymer Solution (2-6) obtained in Example 2-7 was used in place of Polymer Solution (2-1) in the step of producing the organic EL device in Example 2-2.

Organic EL Device (2-8) thus obtained was evaluated by the same method as in Example 2-1. As a result, it was confirmed that light emission is started from voltage of 7.3 V, and a maximum luminous luminance is 740 cd/m².

### Example 2-9:

### (Preparation of solution of polymer composition for organic EL device)

Cyclohexanone was added to a mixed system of 10 g of Polymer (2-1) and Ir(ppy)₃ (compound that x and y in the general formula (3) are 0) in a proportion of 4 mol% based on Polymer (2-1) in such a manner that the solid concentration amounts to 3 % by mass, and the resultant solution was filtered through a filter having a pore size of 2.52 µm, thereby preparing Composition Solution (2-1) with a polymer composition for organic EL devices dissolved in the organic solvent.

Organic EL Device (2-9) was produced in the same manner as in Example 2-1 except that Composition Solution (2-1) was used in place of Polymer Solution (2-1) in the step of producing the organic EL device in Example 2-1.

Organic EL Device (2-9) thus obtained was caused to emit light by the same method as in Example 2-1. As a result, a spectrum derived from Ir(ppy)₃ whose luminescence wavelength is 515 nm was obtained.

From the results described above, it was confirmed that the second conjugated copolymer containing the specific carbazole structural unit and the specific spirofluorene structural unit at the specific proportions is used as a material for forming a luminescent layer, whereby a thin film can be easily formed by the wet method, and an organic EL device that can achieve light emission high in luminous luminance and stable even during continuous driving can be provided.

It was also confirmed that the composition comprising the polymer component composed of the second conjugated copolymer containing the specific carbazole structural unit and the specific spirofluorene structural unit at the specific proportions, and the complex component composed of the iridium complex compound that is a triplet luminescent material is used as a material for forming a luminescent layer, whereby a thin film can be easily formed by the wet method, and an organic EL device that can achieve light emission high in luminous luminance and stable even during continuous driving can be provided.

Since a spectrum derived from Ir(ppy)₃ whose luminescence wavelength is 515 nm was obtained in Organic EL Device (2-9) according to Example 2-9, it was confirmed that light emission is not achieved from a host polymer related to the polymer component making up Composition Solution (2-1), but energy transfer from the host polymer to Ir(ppy)₃ occurs.

According to the polymer for forming an organic EL device according to the present invention, which is composed of the second conjugated polymer, a thin film can be easily formed by the wet method, and an organic EL device that can achieve light emission high in luminous luminance and stable even during continuous driving can be provided, since the second conjugated polymer has the specific carbazole structural unit and the specific spirofluorene structural unit.

When the second conjugated copolymer contains the specific carbazole structural unit and the specific spirofluorene structural unit in the specific proportions, an organic EL device that can achieve light emission still higher in luminous luminance and stable even during continuous driving can be provided.

Since the polymer compositions for organic EL devices according to the present invention contain the second conjugated polymer making up the polymer for forming an organic EL device as a polymer component and are composed of this polymer component and the complex component composed of the iridium complex compound that is a triplet luminescent material, a thin film can be easily formed by the wet method, and an organic EL device that can achieve light emission high in luminous luminance and stable even during continuous driving can be provided.

Since the organic EL devices according to the present invention have a functional organic layer formed by the above-described polymer composition for organic EL devices or polymer for forming an organic EL device, light emission high in luminous luminance and stable even during continuous driving can be achieved.

Disclosed herein are a polymer for forming an organic electroluminescence device and a polymer composition for organic electroluminescence devices, by which a thin film can be formed with ease by the wet method, and an organic electroluminescence device that can achieve light emission high in luminous luminance and stable even during continuous driving can be provided, and the organic electroluminescence device.

The polymer for forming an organic electroluminescence device has specific structural units in its main chain. The polymer composition for organic electroluminescence devices comprises a polymer component composed of the polymer for forming an organic electroluminescence device, and a complex component composed of an iridium complex compound that is a triplet luminescent material. The organic electroluminescence device comprises a functional organic layer having a function as a luminescent layer or charge transport layer formed by the polymer for forming an organic electroluminescence device or the polymer composition for organic electroluminescence devices.

## Claims

1. A polymer for forming an organic electroluminescence device, which is composed of a polymer having, in its main chain, a structural unit represented by the following general formula (1-a) and a structural unit represented by the following general formula (1-b): 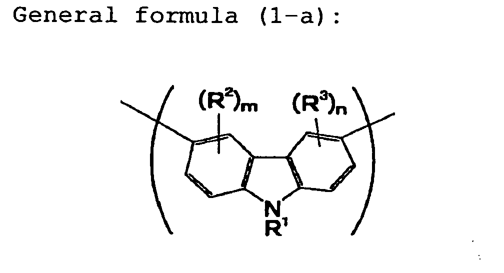 wherein R¹ is an alkyl group or, an aromatic group which may be substituted, R² and R³ are, independently of each other, a substituent of a monovalent organic group and may be the same or different from each other, m is an integer of 0 to 3, and n is an integer of 0 to 3; and 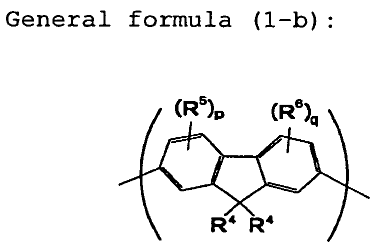 wherein R⁴ is an alkyl group, R⁵ and R⁶ are, independently of each other, a monovalent organic group and may be the same or different from each other, p is an integer of 0 to 3, and q is an integer of 0 to 3, and;
the polymer being used for forming an electroluminescence device.

2. The polymer according to claim 1 for forming an organic electroluminescence device, which comprises a structural unit represented by the following general formula (a): 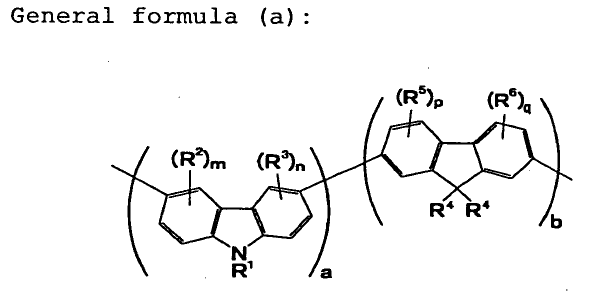 wherein R¹ is an alkyl group or, an aromatic group which may be substituted, R² and R³ are, independently of each other, a substituent of a monovalent organic group and may be the same or different from each other, R⁴ is an alkyl group, R⁵ and R⁶ are, independently of each other, a monovalent organic group and may be the same or different from each other, m is an integer of 0 to 3, n is an integer of 0 to 3, p is an integer of 0 to 3, q is an integer of 0 to 3, and a and b are the numbers of repeated structural units.

3. The polymer according to claim 1 for forming an organic electroluminescence device, which comprises a structural unit represented by the following general formula (b): 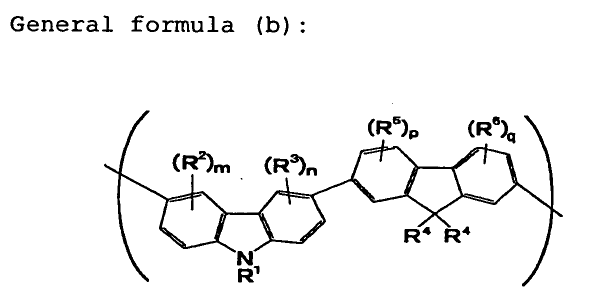 wherein R¹ is an alkyl group or, an aromatic group which may be substituted, R² and R³ are, independently of each other, a monovalent organic group and may be the same or different from each other, R⁴ is an alkyl group, R⁵ and R⁶ are, independently of each other, a monovalent organic group and may be the same or different from each other, m is an integer of 0 to 3, n is an integer of 0 to 3, p is an integer of 0 to 3, and q is an integer of 0 to 3.

4. The polymer according to any one of claims 1 to 3 for forming an organic electroluminescence device, which has a weight average molecular weight of 5,000 to 1,000,000 in terms of polystyrene as measured by gel permeation chromatography.

5. A polymer composition for organic electroluminescence devices, comprising a polymer component composed of the polymer according to any one of claims 1 to 4 for forming an organic electroluminescence device, and a complex component composed of an iridium complex compound that is a triplet luminescent material.

6. An organic electroluminescence device comprising a functional organic layer having a function as a luminescent layer or charge transport layer formed by the polymer composition according to claim 5 for organic electroluminescence devices.

7. A polymer having, in its main chain, a structural unit represented by the following general formula (2-a) and a structural unit represented by the following general formula (2-b): 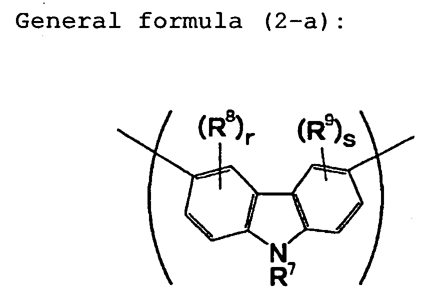 wherein R⁷ is an alkyl group or, an aromatic group which may be substituted, R⁸ and R⁹ are, independently of each other, a monovalent organic group and may be the same or different from each other, r is an integer of 0 to 3, and s is an integer of 0 to 3; and 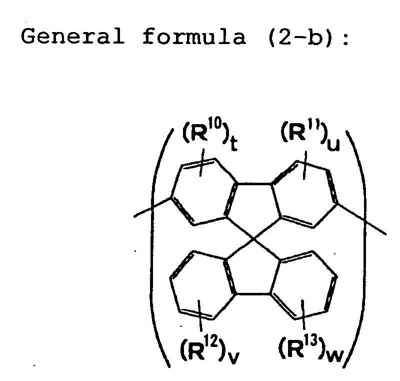 wherein R¹⁰ and R¹¹ are, independently of each other, a monovalent organic group and may be the same or different from each other, R¹² and R¹³ are, independently of each other, a monovalent organic group and may be the same or different from each other, t is an integer of 0 to 3, u is an integer of 0 to 3, v is an integer of 0 to 4, and w is an integer of 0 to 4.

8. A polymer for forming an organic electroluminescence device, which is composed of the polymer according to claim 7 and is used for forming an organic electroluminescence device.

9. The polymer according to claim 8 for forming an organic electroluminescence device, which comprises a structural unit represented by the following general formula (c): 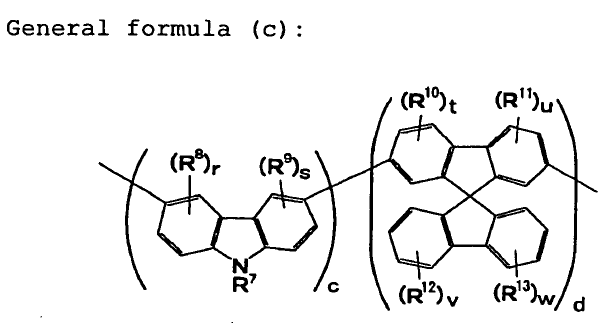 wherein R⁷ is an alkyl group or, an aromatic group which may be substituted, R⁸ and R⁹ are, independently of each other, a monovalent organic group and may be the same or different from each other, R¹⁰ and R¹¹ are, independently of each other, a monovalent organic group and may be the same or different from each other, R¹² and R¹³ are, independently of each other, a monovalent organic group and may be the same or different from each other, r is an integer of 0 to 3, s is an integer of 0 to 3, t is an integer of 0 to 3, u is an integer of 0 to 3, v is an integer of 0 to 4, w is an integer of 0 to 4, and c and d are the numbers of repeated structural units.

10. The polymer according to claim 9 for forming an organic electroluminescence device, wherein a ratio (d/c) of the numbers c and d of repeated structural units in the general formula (c) is 1 to 5.

11. The polymer according to any one of claims 8 to 10 for forming an organic electroluminescence device, wherein the polymer is obtained by subjecting a monomer having 2 functional groups selected from reactive halide functional groups and boron derivative functional groups and a skeletal structure derived from carbazole, and a monomer having 2 functional groups selected from reactive halide functional groups and boron derivative functional groups and a skeletal structure derived from spirofluorene to a coupling reaction in the presence of a palladium catalyst.

12. The polymer according to any one of claims 8 to 11 for forming an organic electroluminescence device, which has a weight average molecular weight of 5,000 to 1,000,000 in terms of polystyrene as measured by gel permeation chromatography.

13. A polymer composition for organic electroluminescence devices, comprising a polymer component composed of the polymer according to any one of claims 8 to 12 for forming an organic electroluminescence device, and a complex component composed of an iridium complex compound that is a triplet luminescent material.

14. An organic electroluminescence device comprising a functional organic layer having a function as a luminescent layer or charge transport layer formed by the polymer according to any one of claims 8 to 12 for forming the organic electroluminescense device.

15. An organic electroluminescence device comprising a functional organic layer having a function as a luminescent layer or charge transport layer formed by the polymer composition according to claim 13 for organic electroluminescence devices.

16. The organic electroluminescence device according to claim 14 or 15, which has a hole blocking layer.
